# EUROPÄISCHE PATENTSCHRIFT

(11) **EP 1 119 774 B1**
(45) Veröffentlichungstag und Bekanntmachung des Hinweises auf die Patenterteilung: **14.01.2004**
(21) Anmeldenummer: 99947435.6
(22) Anmeldetag: 29.09.1999
(51) Int. Cl.: G01R 23/16

(54) **FREQUENZGANGANALYSATOR**
FREQUENCY RESPONSE ANALYZER
ANALYSEUR DE COURBES DE FREQUENCES

(30) Priorität: 05.10.1998 DE 19845744
(43) Veröffentlichungstag der Anmeldung: 01.08.2001
(73) Patentinhaber: Den Dulk, Gerard, 56414 Hundsangen (DE); Schaumburg, Gerhard, 56410 Montabaur (DE)
(72) Erfinder: SCHAUMBURG, Gerhard, D-56410 Montabaur (DE)
(74) Vertreter: Jordan, Volker, Dr.
(86) Internationale Anmeldenummer: PCT/EP1999/007218
(87) Internationale Veröffentlichungsnummer: WO 2000/020875

(56) Entgegenhaltungen:
- EP-A- 0 153 479
- EP-A- 0 268 447
- EP-A- 0 278 669
- EP-A- 0 340 021
- EP-A- 0 841 569
- FR-A- 2 448 722

## Beschreibung

Die Erfindung betrifft einen Analysator, insbesondere Frequenzganganalysator, zum Messen wenigstens einer sich auf eine Frequenz beziehenden Eigenschaft eines zu untersuchenden Systems, insbesondere zum Messen der Reaktion des zu untersuchenden Systems auf wenigstens ein periodisches Treibersignal fester oder variabler Frequenz. Ein derartiger Analysator weist üblicherweise Einrichtungen auf, um wenigstens ein periodisches Treibersignal variabler Frequenz zu erzeugen, zu dem zu untersuchenden System zuzuführen, wenigstens ein Ausgangssignal von dem zu untersuchenden System zu empfangen und das wenigstens eine Ausgangssignal weiter zu verarbeiten, um wenigstens eine, die Reaktion des Systems auf das wenigstens eine Treibersignal charakterisierende Größe zu bestimmen. Derartige Frequenzganganalysatoren sind in verschiedenen Ausführungen bekannt.

Beispielsweise beschreibt die EP 0 268 447 B1 einen Frequenzganganalysator, bei dem zur Auswertung des Ausgangssignals des zu untersuchenden Systems das Ausgangssignal mit einem Sinus- und einem Cosinus-Referenzsignal multipliziert wird. Nach Integration und Analog-zu-Digital-Wandlung ergeben sich Größen, aus denen sich interessierende Größen unmittelbar (insbesondere ohne jede Fouriertransformation) ableiten lassen.

Das das zu untersuchende System antreibende Treibersignal und die Referenzsignale werden mittels eines Taktgenerators, eines Zählers und mehrerer Festwertspeicher erzeugt, wobei im Falle des Treibersignals die digitale Ausgabe eines zugeordneten Festwertspeichers mittels eines D/A-Wandlers zum analogen Treibersignal umgewandelt wird und im Falle der Referenzsignale die Ausgaben zugeordneter Festwertspeicher direkt einem jeweiligen multiplizierenden Digital-Analog-Wandler zugeführt werden, der das analoge Ausgangssignal des zu untersuchenden Systems mit dem betreffenden Referenzsignal multipliziert und ein analoges Ausgangssignal abgibt, das einem integrierenden A/D-Wandler zugeführt wird.

Ferner sind Frequenzganganalysatoren bekannt, bei dem ebenfalls eine Multiplikation zwischen dem Ausgangssignal des zu untersuchenden Systems und Referenzsignalen durchgeführt wird, wobei im Gegensatz zum Analysator der EP 0 268 447 B1 die Referenzsignale in analoger Form vorliegen und die Multiplikation dementsprechend zwischen dem analogen Ausgangssignal und dem jeweiligen analogen Referenzsignal mittels eines analogen Multiplizierglieds durchgeführt wird. Als Beispiel wird hierzu auf die GB-PS 1 540 160 verwiesen.

Aus der EP 0 340 021 B1 ist eine Frequenzganganalyseanordnung bekannt, bei der die Frequenz eines nicht näher spezifizierten Signalgenerators mittels einer PLL-Schaltung zu einer höheren Frequenz F gewissermaßen hochtransformiert wird, um ein Treibersignal mit dieser Frequenz F bereitzustellen. Gleichzeitig wird ein Lokaloszillatorsignal bei einer niedrigeren Frequenz F-C bereitgestellt. Das Treibersignal der Frequenz F, die zum Ausgangssignal des Signalgenerators in einem festen, durch die Divisionskonstante eines Dividierglieds in der PLL-Schaltung bestimmten Verhältnis steht, wird dem zu untersuchenden System zugeführt und ein Ausgangssignal des zu untersuchenden Systems und das Signal mit der Frequenz F-C werden in einem Mischer miteinander gemischt, um ein Signal mit der Differenzfrequenz C zu erzeugen, das in einem Analysator analysiert wird. Es ist vorgesehen, daß dem Analysator ein Referenzsignal ebenfalls mit der Frequenz C zugeführt wird, welches dieser für die Analyse benötigt. Dies ist ein Hinweis darauf, daß der Analysator die Analyse durchführt, indem das Referenzsignal (Frequenz C) mit dem Mischerausgangssignal mit der Differenzfrequenz C multipliziert wird, so daß die Frequenzganganalyse ohne Durchführung von Fouriertransformationen erfolgen dürfte. Die EP 0 340 021 B1 geht davon aus, daß der Analysator auf eine Eingabe mit fester Frequenz beschränkt ist.

Aus der EP 0 278 669 A2 ist ein Verfahren und eine Vorrichtung zur Frequenzganganalyse bekannt, bei denen ein einem zu untersuchenden System zuzuführendes Frequenzsignal auf Grundlage eines Ausgangssignals niedrigerer Frequenz eines Frequenzsynthesizers durch Hochtransformierung auf die benötigte höhere Frequenz erzeugt wird. Hierbei werden PLL-Schaltungen, Mixer zur Signalmultiplizierung und Frequenzteiler eingesetzt.

Die EP 0 841 569 A2 offenbart einen Spektrumanalysator, der eine Frequenzanalyse auf Grundlage von digitalisierten Zwischenfrequenzsignalen durchführt, zu denen Eingangssignale mittels eines Lokaloszytlatorsignals und eines Mischers gemischt werden.

Die EP 0 153 479 A2 offenbart u.a. einen RF-Vektor-Netzanalysator. Der Analysator enthält Frequenzumwandlungsschaltungen, eine Hochfrequenz-Quelle miteinstellbarer Frequenz und Synchrondetektoren, um nur einige im Fachgebiet übliche Bestandteile derartiger Geräte zu nennen. Die Offenlegungsschrift beschreibt vor allem ein sich auf ein derartiges Gerät beziehendes Datenverarbeitungssystem.

Aus der DE 30 01 499 C2 ist ein Verfahren und eine Schaltungsanordnung zum Analysieren der Wellenform eines periodischen Signals bekannt, wobei sich die Patentschrift nach Beschreibungseinleitung und Ausführungsbeispiel auf die Bestimmung des Oberwellengehalts in einem elektrischen Versorgungsnetz bezieht.

Die zum Analysieren der Wellenform verwendete Analyseanordnung weist einen A/D-Wandler auf, durch den das zu analysierende periodische Signal (die zu untersuchende Netzspannung) abgetastet wird. Der A/D-Wandler wird von einer Schaltungsanordnung getriggert, die die Periodendauer der Netzfrequenzperiode mißt und Triggersignale an den A/D-Wandler und eine vorgeschaltete Halteschaltung abgibt, so daß die Netzfrequenz - obwohl die Netzfrequenz zwischen 48 und 51 Hz schwanken kann - pro Netzfrequenzperiode 64 mal bei gleichbeabstandeten Phasenwinkeln abgetastet wird, so daß von Periode zu Periode im wesentlichen bei den gleichen Phasenwinkeln abgetastet wird.

Die über mehrere aufeinanderfolgende Perioden gewonnenen Abtastwerte werden, für jeden Phasenwinkel gesondert, in einem Speicher akkumuliert, um eine resultierende "mittlere" Wellenform mit entsprechend größerer Amplitude und deutlich verbessertem Signal-zu-Rausch-Verhältnis zu erhalten. Die die mittlere Wellenform repräsentierenden akkumulierten Abtastwerte werden in einem Fouriertransformationsschaltkreis fouriertransformiert, um Amplituden und Phasenwinkel der Oberwellen zu erhalten.

Das Leistungsvermögen (Performance) von Frequenzganganalysatoren, die wie die aus der DE 30 01 499 C2 bekannte Anordnung auf dem Abtasten von zu analysierenden Signalen mit nachfolgender (diskreter) Fouriertransformation beruhen, ist generell durch die Genauigkeit der Wandlung und die Abstastrate des verwendeten A/D-Wandlers begrenzt. Die erforderliche Abtastrate steigt linear mit der Frequenz des zu analysierenden Signals. Beispielsweise ist für ein 40 MHz Signal nach dem Abtasttheorem eine Abtastrate größer als 80 MHz erforderlich. Für die Durchführung einer digitalen Fouriertransformation in Echtzeit ist dementsprechend eine digitale Prozessoreinrichtung oder dergleichen mit extrem hoher Prozessorleistung (beispielsweise mit mehreren parallel arbeitenden Prozessoren oder/und mit Spezialhardware) erforderlich. Überdies stehen hochgenaue A/D-Wandler mit einer Genauigkeit von 16 Bit oder größer nur bis zu Abtastfrequenzen von einigen 100 KHz zur Verfügung. Die obere Frequenz eines hochpräzisen Abtastsystems ist deshalb auf diese Frequenzen beschränkt, wobei selbst für solche Systeme die Genauigkeit oberhalb von 10 KHz abnimmt.

Ein weiteres Problem liegt darin, daß im Falle eines auf der Abtastung eines Ausgangssignals von einem zu untersuchenden System beruhenden Frequenzganganalysators, bei dem zur Bestimmung wenigstens einer, die Reaktion des Systems auf das Treibersignal charakterisierenden Größe die Abtastwerte einer digitalen Fouriertransformation unterworfen werden, die Genauigkeit durch Synchronisationsfehler begrenzt wird. Wird beispielsweise das dem zu untersuchenden System zugeführte periodische Treibersignal mittels eines D/A-Wandlers erzeugt, so kann zwar die Abtastfrequenz des A/D-Wandlers gleich der Frequenz sein, mit der der D/A-Wandler digitale Eingangswerte in analoge Ausgangswerte umwandelt. Damit besteht aber noch keine Synchronisation zwischen der Treibersignalfrequenz und der Abtastrate, woraus Timingfehler im Algorithmus der digitalen Fouriertransformation resultieren, die schwer zu kompensieren sind.

Wird hingegen die Frequenzganganalyse auf eine analoge oder analog/digitale Weise durch Multiplikation des Ausgangssignals des zu untersuchenden Systems mit einem Referenzsignal durchgeführt (vgl. die EP 0 268 447 B1, die EP 0 340 021 B1 und die GB-PS 1 540 160), so ist das Leistungsvermögen (Performance) des Frequenzganganalysators bzw. der Frequenzganganalyseanordnung durch die Genauigkeit der verwendeten elektronischen Komponenten, insbesondere der Multiplizierglieder und Intergrationsglieder, begrenzt. Besonders problematisch ist, wenn eine in-Phase-Komponente und eine Quadratur-Komponente mittels zwei unabhängigen Signalwegen abgeleitet werden.

Jede Abweichung zwischen den Komponenten der beiden Signalwege hat Phasen- und Amplitudenfehler zur Folge, die nicht-linear sind und deshalb schwierig zu kompensieren sind. Zusätzliche Probleme treten bei niedrigen Frequenzen auf, da dann die Zeitkonstanten der verwendeten Integrierglieder unakzeptabel hohe Werte annehmen müssen.

Demgegenüber ist es eine Aufgabe der vorliegenden Erfindung, einen Analysator der eingangs genannten Art bereitzustellen, der eine Messung, insbesondere Frequenzganganalyse, über einen großen Frequenzbereich ermöglicht.

Ferner ist es eine Aufgabe der vorliegenden Erfindung, einen Analysator der eingangs genannten Art bereitzustellen, der mit hoher Genauigkeit Messen bzw. die die Reaktion des Systems auf das Treibersignal charakterisierende Größe bestimmen kann.

Zur Lösung wenigstens einer dieser Aufgaben wird ein Analysator, ggf. Frequenzganganalysator, mit den Merkmalen des Anspruchs 1 bereitgestellt. Zwei vorteilhafte Ausprägungen des erfindungsgemäßen Analysators ergeben sich aus den Ansprüchen 2 und 3. Vorteilhafte Weiterbildungen sind in den Ansprüchen 4 bis 33 angegeben.

Betreffend die Übertragungsmittel wird darauf hingewiesen, dass das erste Signal (Treibersignal) über eine Signalaufbereitungsanordnung zum zu untersuchenden System übertragen werden könnte, wenn zweckmäßig.

Betreffend die Mischer- oder Abtastanordnung wird darauf hingewiesen, dass diese die zugeführten Signale (weiteres Signal und wenigstens ein Systemausgangssignal) über eine jeweilige Signalaufbereitungsanordnung empfangen könnte, wenn zweckmäßig.

Der zweite Signalgenerator und die Mischeranordnung ermöglichen, daß die die Reaktion des Systems auf das Treibersignal charakterisierende Größe durch Auswerten eines gegenüber der Treibersignalfrequenz bei einer niedrigeren Frequenz schwingenden Mischeranordnungsausgangssignals bestimmt wird, indem dieses Mischerausgangssignal (das Mischerausgangssignal mit der niedrigeren Frequenz) mittels der Analog-zu-Digital-Wandler-Anordnung abgetastet wird und die digitale Prozessoranordnung auf Grundlage der Abtastwerte die die Reaktion des Systems auf das Treibersignal charakterisierende Größe bestimmt. Für die Frage, ob die Abtastrate (insbesondere in Hinblick auf das Abtasttheorem) ausreichend hoch ist, um keinen Informationsverlust zu erleiden, kommt es nunmehr auf das Verhältnis der Abtastfrequenz zur Frequenz der der Analog-zu-Ditital-Wandler-Anordnung zugeführten Komponente des Mischeranordnungsausgangssignal an, so daß eine kleinere Abtastfrequenz ausreicht, als wenn direkt das Systemausgangssignal abgetastet werden würde. Dementsprechend sind die Anforderungen an die Schnelligkeit der die Analog-zu-Digital-Wandler-Anordnung reduziert und es können hochpräzise A/D-Wandler mit einer vergleichsweisen kleinen maximalen Abtastrate eingesetzt werden. Damit kann eine hohe Genauigkeit über einen großen Frequenzbereich erreicht werden, beispielsweise über einen Frequenzbereich von 10⁻⁵ Hz bis 4×10⁷ Hz (10 µ Hz bis 40 MHz). Ein derartiger Frequenzbereich ist beispielsweise für die Anwendung des Analysators bzw. Frequenzganganalysators bei der Materialanalyse, insbesondere bei der dielektrischen Spektroskopie bzw. Impedanzspektroskopie, von Interesse.

In Verbindung mit der durch das Triggersignal definierten Abtastung lassen sich Phasenwinkel mit einer extrem hohen Präzision in der Größenordnung wenigstens von 0,01 ° messen, was insbesondere für die genannten Anwendungen in der Materialanalyse, insbesondere der dielektrischen oder Impedanzspektroskopie, von hoher Bedeutung ist, bei der aus einer gemessenen Impedanz einer Kondensatoranordnung, in der zu untersuchendes Material angeordnet ist, beispielsweise die dielektrische Funktion und der Verlustfaktor tan (δ) des zu untersuchenden Materials bestimmt werden. Bei Materialien mit niedrigen Verlusten kann tan (δ) sehr klein werden (10⁻⁴ und kleiner), so daß für die Bestimmung des Phasenwinkels zwischen Spannung und Strom an der Kondensatoranordnung eine extrem hohe Präzision erforderlich ist.

Da für die Bereitstellung des dem zu untersuchenden System zugeführten Treibersignals ein erster Signalgenerator und zur Bereitstellung des periodischen Lokaloszillatorsignals ein gesonderter zweiter Signalgenerator vorgesehen sind, lassen sich in einem weiten Umfang beliebige ganzzahlige oder gebrochen-rationale Verhältnisse zwischen der Treibersignalfrequenz und der Lokaloszillatorsignalfrequenz realisieren, wobei über das periodische Taktsignal, das sowohl Grundlage für das periodische Treibersignal als auch für das Lokaloszillatorsignal ist, eine Synchronisierung erreicht werden kann, so daß stets ein wohldefiniertes ganzzahliges oder gebrochen-rationales Frequenzverhältnis (mit einer definierten Phasenbeziehung zwischen den Phasen der beiden Signale) gewährleistet ist.

Gegenüber aus dem Stand der Technik bekannten Ansätzen, bei denen die digitale Prozessoreinrichtung einer Digital-zu-Analog-Wandler-Anordnung digitale, das Treibersignal repräsentierende Werte zuführt, die durch die Digital-zu-Wandler-Anordnung in das periodische analoge Treibersignal umgewandelt wird, bietet der angegebene Aufbau des Analysators bzw. Frequenzganganalysators den großen Vorteil, daß die digitale Prozessoreinrichtung von der Bereitstellung der digitalen, das Treibersignal repräsentierenden Werte entlastet ist, wenn der erste Signalgenerator in Zusammenarbeit mit dem Taktgenerator das periodische Treibersignal eigenständig erzeugen kann. Entsprechendes gilt für den zweiten Signalgenerator, wenn dieser in Zusammenarbeit mit dem Taktgenerator eigenständig das Lokaloszillatorsignal bereitstellen kann. Die digitale Prozessoreinrichtung, die dann, je nach Auslegung des Analysators, ggf. den Generatoren Steuersignale zuführt, die beispielsweise das Frequenzverhältnis zwischen Treibersignal und Taktsignal bzw. das Frequenzverhältnis zwischen Lokaloszillatorsignal und Taktsignal bestimmen, braucht dann nämlich ansonsten nur noch die zum Empfang der Abtastwerte und zur Bestimmung der die Reaktion des Systems auf das Treibersignal charakterisierenden Größe erforderlichen Verarbeitungen durchführen, so daß insgesamt ein geringerer Verarbeitungsaufwand erforderlich ist. Dieser Verarbeitungsaufwand ist auch schon allein dadurch reduziert, daß für hochfrequente Treibersignate das Mischeranordnungsausgangssignal bzw. dessen niederfrequente Komponente mit vergleichsweise niedriger Abtastfrequenz abgetastet werden kann, so daß im Falle einer Auswertung des abgetasteten Signals mittels einer digitalen Fouriertransformation vergleichsweise niedrige Taktfrequenzen für den internen Takt der Prozessoreinrichtung ausreichen. Damit werden einerseits hohe Frequenzbereiche für die Analyse durch Abtastung eines die Information über die Reaktion des Systems auf das Treibersignal enthaltenden Signals und nachfolgender digitaler Fouriertransformation zugänglich und es können andererseits vergleichsweise kostengünstige, nicht unbedingt den neuesten Stand der Technik hinsichtlich der Verarbeitungsgeschwindigkeit darstellende Mikroprozessoren und dergleichen für den Aufbau der digitalen Prozessoreinrichtung eingesetzt werden.

Vorteilhaft ist der Triggersignalgenerator, der auf Grundlage des Taktsignals ein periodisches Triggersignal mit einer einstellbaren Triggersignalfrequenz bereitstellt, die mit der Taktsignalfrequenz in einem ganzzahligen oder gebrochen-rationalen Verhältnis steht. Das Triggersignal kann der Analog-zu-Digital-Wandler-Anordnung zugeführt werden, um diese zu triggern, damit sie das Eingangssignal an durch das Triggersignal bestimmten Zeitpunkten abtastet. Durch diese Weiterbildung bzw. Ausprägung läßt sich ohne großen schaltungstechnischen Aufwand eine besonders hohe Genauigkeit über den genannten großen Frequenzbereich erreichen, da eine eindeutige Synchronisierung zwischen dem Ausgangssignal des zu untersuchenden Systems bzw. dem der Analog-zu-Digital-Wandler-Anordnung zugeführten Mischeranordnungsausgangssignal und dem Triggersignal möglich ist (beide werden ja auf Grundlage des Taktsignals erzeugt), so daß das Systemausgangssignal oder dieses Mischeranordnungsausgangssignal an wohldefinierten Zeitpunkten bzw. Phasen des betreffenden Signals abgetastet wird. Da, wie schon gesagt, auch das Triggersignal auf Grundlage des Taktsignals erzeugt wird, kann also ohne großen schaltungstechnischen Aufwand erreicht werden, daß die Triggersignalfrequenz, einerseits und die Treibersignalfrequenz bzw. die Frequenz der Analog-zu-Digital-Wandler-Anordnung zugeführten Komponente des Mischeranordnungsausgangssignals mit der niedrigeren Frequenz, andererseits, in einem wohldefinierten ganzzahligen oder gebrochen-rationalen Verhältnis stehen (mit einer definierten Phasenbezeichnung zwischen den Phasen der beiden Signale). Im Falle einer Auswertung der Abtastsignale durch digitale Fouriertransformation werden damit Synchronisations- bzw. Timingfehler im Fouriertransformationsalgorithmus, die schwer zu kompensieren wären, vermieden. Der Triggersignalgenerator kann wie der erste und der zweite Signalgenerator derart ausgebildet sein, daß er ohne wesentlichen Verarbeitungsaufwand für die digitale Prozessoreinrichtung das Triggersignal in Zusammenarbeit mit dem Taktgenerator eigenständig erzeugt.

Durch die digitale Prozessoreinrichtung sind vorzugsweise mehrere Triggersignalfrequenzen einstellbar, insbesondere wenigstens 16 verschiedene Triggersignalfrequenzen, um eine im Hinblick auf das Abtasttheorem hinreichende, aber ggf. im Hinblick auf den Prozessoraufwand für die Auswertung der Abtastssignale optimierte Abtastung vorzusehen.

Bevorzugt ist auch eine sog. "Unterabtastung" mit einer das Abtasttheorem nicht erfüllenden Abtastfrequenz kleiner als das Doppelte der Frequenz des abgetasteten Signals möglich. Bei einer derartigen Unterabtastung wird periodisch über mehrere Perioden mit versetzten Abtastpunkten (Abtastphasenwinkeln) abgetastet, um Frequenzanteile oberhalb der gemäß dem Abtasttheorem an sich aus der Abtastfrequenz resultierenden Grenzfrequenz zu erfassen. Eine derartige Unterabtastung setzt eine exakte (wohldefinierte) Synchronisation zwischen dem abgetasteten Signal und dem die Abtastzeitpunkte bestimmenden Triggersignal voraus, die gemäß dem diskutierten Weiterbildungsvorschlag gewährleistet ist. Durch die Unterabtastung kann auch ohne Herabmischen des Systemausgangssignals mittels der Mischeranordnung ein großer Frequenzbereich für den Analysator bzw. Frequenzganganalysator mit vergleichsweise hoher Genauigkeit erreicht werden.

Bevorzugt ist die Treibersignalfrequenz oder/und die Triggersignalfrequenz oder/und die Lokaloszillatorsignalfrequenz kleiner als die Taktsigalfrequenz. Die zur Erzeugung der genannten Frequenzen auf Grundlage des Taktsignals verwendeten Signalgeneratoren können dann besonders einfach aufgebaut sein und beispielsweise das jeweilige Generatorausgangssignal durch Herabteilen des Taktsignals erzeugen.

Zum Vorsehen eines großen Frequenzbereichs des Analysators, insbesondere Frequenzganganalysators, kann der Analysator zwischen einem ersten Betriebsmodus und einem zweiten Betriebsmodus umschaltbar sein, wobei im ersten Betriebsmodus das Systemausgangssignal, ggf. über eine Signalaufbereitungsanordnung, der Analog-zu-Digital-Wandler-Anordnung als dem Ausgangssignal entsprechendes Eingangssignal zugeführt wird und im zweiten Betriebsmodus das Systemausgangssignal, ggf. über eine/die Signalaufbereitungsanordnung, der das Lokaloszillatorsignal empfangenden Mischeranordnung zugeführt wird und die Komponente des Mischeranordnungsausgangssignals mit der niedrigeren Frequenz, ggf. über eine Signalaufbereitungsanordnung, der Analog-zu-Digital-Wandler-Anordnung als für das Systemausgangssignal repräsentatives Eingangssignal zugeführt wird.

Als Alternative zu der beschriebenen Ausbildung mit zweitem Signalgenerator zum Erzeugen des Lokaloszillatorsignals und der Mischeranordnung, oder zusätzlich hierzu, wird vorgeschlagen, daß der Analysator in wenigstens einen Betriebsmodus das Eingangssignal zur Analog-zu-Digital-Wandler-Anordnung, insbesondere das Systemausgangssignal, mit einer Abtastfrequenz kleiner als das Doppelte der Eingangssignalfrequenz abtastet (sogenannte Unterabtastung).

Die oben schon kurz angesprochene Unterabtastung ermöglicht es, bei einem periodischen Signal auch Signalfrequenzanteile mit Frequenzen jenseits einer durch die Abtastfrequenz bestimmten Grenzfrequenz (Abtasttheorem) zu erfassen. Der Signalverlauf in einer Periode ergibt sich erst aus der Zusammenführung der Abtastergebnisse über mehrere Perioden mit versetzten Abtastpunkten. Voraussetzung hierfür ist eine exakte, wohldefinierte und wiederholbare Synchronisierung zwischen der Frequenz des abzutastenden Signals (Eingangssignal zur Analog-zu-Digital-Wandler-Anordnung) und der Abtastfrequenz bzw. dem Triggersignal.

Um auch Eingangssignalfrequenzanteile mit Frequenzen über einer GrenzfrequenzeinerAnalog-zu-Digital-Wandler-Schaltungsanordnungder Analog-zu-Digital-Wandler-Anordnung erfassen zu können, wird weiterbildend vorgeschlagen, daß die Analog-zu-Digital-Wandler-Anordnung eine Sample-Hold-Schaltungsanordnung (mit entsprechend hoher Grenzfrequenz) umfaßt. Diese Weiterbildung ist besonders vorteilhaft im Zusammenhang mit der beschriebenen Unterabtastung, da hierdurch der Frequenzbereich des Frequenzganganalysators zu besonders hohen Meßfrequenzen hin ausgeweitet werden kann.

Vorzugsweise sind die Generatoren des Analysators derart ausgelegt und ansteuerbar, daß das Lokaloszillatorsignal und das Treibersignal für alle nutzbaren Treibersignalfrequenzen einen identischen Frequenzabstand aufweisen bzw. aufweisen können. Damit wird für alle nutzbaren Treibersignalfrequenzen das Mischeranordnungsausgangssignal zur gleichen Frequenz (Differenzfrequenz) herabgemischt und die Analog-zu-Digital-Wandler-Anordnung und dieser zugeordnete Komponenten können für eine Verarbeitung eines Signals bei dieser Frequenz optimiert sein.

Sollen höhere Fourierkomponenten (Harmonische) bestimmt werden, so ist es vorteilhaft, wenn in diesem Fall die Lokaloszillatorfrequenz auf die Frequenz der interessierenden Harmonischen, vermindert oder vergrößert um die gewünschte Differenzfrequenz, eingestellt wird. Nach der Mischung erscheint dann die interessierende Fourierkomponente des Eingangssignals bei der Differenzfrequenz am Wandler. Als Differenzfrequenz ist vorzugsweise die gleiche Differenzfrequenz wie bei der Bestimmung einer Basisband-Fourierkomponente zu wählen, so daß die Abtastung und die digitale Fouriertransformation im wesentlichen genauso wie bei der Bestimmung einer Basisband-Fourierkomponente durchgeführt werden kann. Zu erwähnen ist noch, daß die Bestimmung von höheren Fourierkomponenten nicht das Herabmischen des Systemausgangssignals voraussetzt, sondern daß alternativ die höheren Fourierkomponenten auch auf Basis von durch Unterabtastung erhaltenen Abtastwerten bestimmt werden können.

Besonders vorteilhaft ist es, wenn die Triggersignalfrequenz, einerseits, und die Treibersignalfrequenz oder/und die Frequenz der der Analog-zu-Digital-Wandler-Anordnung zugeführten Komponente des Mischeranordnungsausgangssignals mit der niedrigeren Frequenz, andererseits, in einem ganzzahligen oder gebrochen-rationalen Verhältnis stehen, das durch die digitale Prozessoreinrichtung einstellbar ist, insbesondere quasi-kontinuierlich einstellbar ist. Nach dieser Weiterbildung kann ein auf die Meßsituation abgestimmtes Verhältnis von Abtastfrequenz und Frequenz des abgetasteten Signals eingestellt werden. Im Falle des Herabmischens des Systemausgangssignals kann man diese Weiterbildung auch so formulieren, daß die Triggersignalfrequenz, Treibersignalfrequenz und Lokaloszillatorsignalfrequenz in ganzzahligen oder gebrochen-rationalen Verhältnissen zueinander stehen, die durch die digitale Prozessoreinrichtung einstellbar sind, insbesondere quasi-kontinuierlich einstellbar sind.

Um eine quasi-kontinuierliche Frequenzeinstellbarkeit oder eine einer kontinuierlichen oder quasi-kontinuierlichen Frequenzeinstellbarkeit zumindest angenäherte Frequenzeinstetlbarkeit vorzusehen, wird vorgeschlagen, daßdurch die digitale Prozessoreinrichtung als Treibersignalfrequenz oder/und als Lokaloszillatorfrequenz oder/und als Triggersignalfrequenz wenigstens 2⁴ verschiedene, vorzugsweise wenigstens 2⁸ verschiedene, noch stärker bevorzugt wenigstens 2¹⁶ verschiedene, höchstvorzugsweise wenigstens 2³² verschiedene Frequenzen einstellbar sind.

In diesem Zusammenhang ist es bevorzugt, daß als ganzzahliges oder gebrochen-rationales Verhältnis jeder Wert V = N₁/N₂ durch die digitale Prozessoreinrichtung einstellbar ist, wobei N₁ und N₂ beliebige natürliche Zahlen größer Null sind und sich als digitale Integerzahlen mit wenigstens 8 Bit, vorzugsweise wenigstens 16 Bit, höchstvorzugsweise wenigstens 32 Bit, darstellen lassen. Damit sind faktisch beliebige Verhältnisse von Abtastfrequenz zu Frequenz des abgetasteten Signals möglich. Beispielsweise wird im Falle einer Darstellbarkeit der natürlichen Zahlen N₁ und N₂ durch eine 32-Bit-Integer-Zaht ein Frequenzverhältnisbereich entsprechend einem Durchlauf der beiden natürlichen Zahlen jeweils von 1 bis 2³² (alle Kombinationen) erreicht.

Entsprechend der Signalerzeugung des erfindungsgemäßen Analysators, insbesondere Frequenzganganalysators, mittels gesonderter Signalgeneratoren auf Grundlage des Taktsignals kann das Frequenzverhältnis zwischen Abtastfrequenz und Frequenz des abgetasteten Signals (Treibersignal bzw. Mischeranordnungsausgangssignal) oder/und der Frequenzabstand zwischen Treibersignal und Lokaloszillatorsignal (und damit die Differenzfrequenz) dadurch einstellbar sein, daß das ganzzahlige oder gebrochen-rationale Verhältnis zwischen Treibersignalfrequenz und Taktsignalfrequenz oder/und Triggersignalfrequenz und Taktsignalfrequenz oder/und Lokaloszillatorsignalfrequenz und Taktsignalfrequenz durch die digitale Prozessoreinrichtung einstellbar ist, insbesondere quasi-kontinuierlich einstellbar ist.

In diesem Zusammenhang ist es bevorzugt, daß als ganzzahliges oder gebrochen-rationales Verhältnis jeder Wert W = n₃/n₀ oder/und W = n₀/n₃ durch die digitale Prozessoreinrichtung einstellbar ist, wobei n₀ eine vorgegebene oder beliebige natürliche Zahl größer Null ist und n₃ eine beliebige natürliche Zahl größer Null aus einem vorgegebenen Intervall [n₄, n₅] ist, wobei n₄ und n₅ natürliche Zahlen sind und sich als digitale Integerzahlen mit wenigstens 8 Bit, vorzugsweise wenigstens 16 Bit, höchstvorzugsweise wenigstens 32 Bit, darstellen lassen. Hierzu wird weiterbildend vorgeschlagen, daß n₀ wenigstens 2⁸, vorzugsweise wenigstens 2¹⁶, höchstvorzugsweise wenigstens 2³² beträgt und [n₅ - n₄] wenigstens etwa n₀/4, vorzugsweise wenigstens n₀/3, höchstvorzugsweise wenigstens etwa n₀/2 beträgt, wobei n₄ vorzugsweise gleich Null ist. Ist beispielsweise für n₀ nur eine Zahl vorgegeben, etwa 2³², und reicht das Intervall beispielsweise von 1 bis 2³²/2, so ergibt sich ein Frequenzverhältnisbereich entspreched einem Durchlauf der Zahl n₃ von 1 bis 2³²/2 mit festgehaltenem n₀. Sind mehrere natürliche Zahlen n₀ im genannten Sinne vorgegeben oder ist n₀ beliebig, so ergibt sich ein entsprechend größerer bzw. feiner unterteilter Frequenzverhältnisbereich.

Es wurde schon erwähnt, daß die Signalgeneratoren ihre Ausgangssignale auf Grundlage des Taktsignals dadurch erzeugen können, daß das Taktsignal entsprechend heruntergeteilt wird (digitale Division der Taktfrequenz), ggf. mit nachgeschalteter Signalformung oder/und Signalverstärkung. Als bevorzugte Alternative hierzu wird vorgeschlagen, daß wenigstens einem Generator von erstem Signalgenerator, ggf. Triggersignalgenerator und ggf. zweitem Signalgenerator ein Phasenwert eingebbar ist, um den eine generatorinterne Phase des jeweiligen Ausgangssignals (Treibersignal, Triggersignal bzw. Lokaloszillatorsignal) für jeden Takt des Taktsignals vergrößert wird. Man kann in diesem Fall einen Festfrequenz-Taktgenerator vorsehen, ohne wesentliche Einschränkungen hinsichtlich den bereitstellbaren Frequenzen in Kauf nehmen zu müssen. Der Phasenwert ist bevorzugt in Form eines Werts eingebbar, der die resultierende Frequenz des Generatorausgangssignals als Bruchteil der Frequenz des Taktsignals definiert.

Eine hohe Präzision bei gleichzeitig geringem Schaltungsaufwand kann erreicht werden, wenn die als digitale ganze Zahl repräsentierte generatorinterne Phase die Adresse eines zugeordneten, digital repräsentierten Amplitudenwerts des Generatorausgangssignals in einer generatorinternen Tabelle angibt, der einem das Generatorausgangssignal abgebenden Digital-zu-Analog-Wandler zuführbar ist. Selbstverständlich kann dem Digital-zu-Analog-Wandler noch eine Signal-Formungs- oder/und Verstärkungsschaltung nachgeschaltet sein, die dann das eigentliche Generatorausgangssignal auf Grundlage des vom Digital-zu-Analog-Wandler abgegebenen Signals abgibt.

Eine andere vorteilhafte Ausführungsvariante zeichnet sich dadurch aus, daß wenigstens ein Generator von erstem Signalgenerator, ggf. Triggersignalgenerator und ggf. zweitem Signalgenerator eine PLL-Schaltung umfaßt, die das Taktsignal zu einer höheren oder tieferen Frequenz frequenztransformiert. Weiterbildend wird vorgeschlagen, daß die PLL-Schaltung ein Frequenzmultiplizierglied oder/und ein Frequenzdividierglied mit durch die digitale Prozessoreinrichtung einstellbaremFrequenzmultiplikationsfaktorbzw.Frequenzdivisionsfaktor umfaßt. Die Ausgangsfrequenz des betreffenden Generators kann dann einfach durch Einstellen des Frequenzmultiplikationsfaktors bzw. des Frequenzdivisionsfaktors gewählt werden, wobei aufgrund der Erzeugung der Frequenz bzw. der Frequenzen durch Frequenztransformation aus dem Taktsignal ein definiertes Frequenzverhältnis zur Taktsignalfrequenz bzw. zwischen den Ausgangsfrequenzen der Generatoren besteht. Es ergeben sich die oben diskutierten Vorteile, nämlich eine wohldefinierte Frequenz- und Phasenbeziehung zwischen den in Frage stehenden Signalen.

Um die Abtastwerte der digitalen Prozessoreinrichtung ohne wesentlichen Rechen- und Überwachungsaufwand der Prozessoreinrichtung zuzuführen, kann diese das Triggersignal empfangen und an von durch das Triggersignal bestimmten Zeitpunkten von der Analog-zu-Digital-Wandler-Anordnung bereitgestellte Abtastwerte aufnehmen. Beispielsweise kann das Triggersignal einen Interrupt der Prozessoreinrichtung auslösen, der ein Unterprogramm zur Aufnahme der bereitgestellten Abtastwerte aufruft. Damit kann auf einfache Weise realisiert werden, daß simultan zur Durchführung der Messung eine Auswertung der Abtastwerte, beispielsweise unter Durchführung einer digitalen Fouriertransformation, erfolgt. Die Rechenleistung der digitalen Prozessoreinrichtung kann damit gut ausgenutzt werden.

Um den Frequenzbereich des Analysators, insbesondere Frequenzganganalysators, zu erweitern, kann der Frequenzbereich einer Generatorschaltung wenigstens eines Generators von Taktgenerator, erstem Signalgenerator, ggf. Triggersignalgenerator und ggf. zweitem Signalgenerator, erweiterbar sein, indem eine jeweilige Frequenztransformationsschaltung vorgesehen ist, die der Generatorschaltung nachgeschaltet oder für bestimmte Betriebszustände nachschaltbar ist, um die Ausgangsfrequenz zu tieferen oder/und höheren Frequenzen zu transformieren oder umzusetzen. Die jeweilige Frequenztransformationsschaltung kann ein Frequenz-Dividierglied oder/und ein Frequenz-Potenzierglied (beispielsweise Frequenz-Quadrierglied) oder/und eine PLL-Schaltung (Phase-Locked-Loop) oder/und ein Mischerglied mit zugeordnetem Lokaloszillator umfassen.

Die Bestimmung der wenigstens einen charakterisierenden Größe kann grundsätzlich ohne Durchführung einer Fouriertransformation erfolgen, beispielsweise indem theoretische Funktionen (insbesondere umfassend Sinus- oder/und Cosinusfunktionen) an die Abtastwerte durch Parameteranpassung angepaßt (angefittet) werden bzw. indem die durch die Abtastwerte repräsentierte Wellenform mit derartigen theoretischen Funktionen korreliert wird.

Bevorzugt erfolgt die Bestimmung der charakterisierenden Größe aber unter Durchführung einer digitalen Fouriertransformation auf den Abtastwerten oder auf aus diesen durch Weiterverarbeitung gewonnenen Verarbeitungswerten. Die wenigstens eine charakterisierende Größe kann die relative Amplitude/relativen Amplituden und die relative Phase/relativen Phasen zwischen Fourierkomponenten von wenigstens zwei verschiedenen Ausgangssignalen vom zu untersuchenden System umfassen, wobei insbesondere an die schon erwähnte Anwendung in der Materialanalyse gedacht wird, so daß am Ende der Auswertung der Meßdaten eine dielektrische Funktion und der Verlustfaktor als Funktion der Treibersignalfrequenz stehen könnte. Anstelle der genannten Größen, oder zusätzlich hierzu, kann man auch wenigstens eine Amplitude (Amplitudenabsolutwert) oder/und wenigstens eine auf das Treibersignal bezogene relative Amplitude oder/und wenigstens eine auf das Treibersignal bezogene relative Phase wenigstens einer Fourierkomponente von wenigstens einem Ausgangssignal vom zu untersuchenden System bestimmen.

Hinsichtlich der Realisierung der verschiedenen genannten Komponenten des Analysators bzw. Frequenzganganalysators bestehen viele Möglichkeiten. Eine mögliche Ausführungsform zeichnet sich dadurch aus, daß der Taktgenerator ein interner Taktgenerator der digitalen Prozessoreinrichtung ist oder auf Grundlage eines internen Taktgenerators sowie anderer Hardwarekomponenten oder/und Software-Funktionalitäten der digitalen Prozessoreinrichtung realisiert ist, wobei der erste Signalgenerator oder/und der zweite Signalgenerator oder/und der Triggersignalgenerator auf Grundlage von Hardwarekomponenten der digitalen Prozessoreinrichtung oder/und dieser zugeordneter externer Hardwarekomponenten durch Software-Funktionalitäten der digitalen Prozessoreinrichtung realisiert sind. Bei dem Taktsignal kann es sich beispielsweise um ein einen Prozessorinterrupt auslösendes Signal eines Zeitglieds (Timer) der Prozessoreinrichtung handeln.

Im Falle der Realisierung des Analysators, insbesondere Frequenzganganalysators, zu großen Teilen auf Basis der Prozessoreinrichtung ist es für eine Echtzeitfrequenzanalyse mit einem großen Frequenzbereich bevorzugt, daß die Prozessoreinrichtung mehrere parallel arbeitende Prozessoren oder/und wenigstens einen Hochgeschwindigkeitssignalprozessor oder/und Spezialhardware, beispielsweise zur Durchführung von Fouriertransformationen, umfaßt.

Eine andere bevorzugte Ausführungsform, die oben schon angesprochen wurde, zeichnet sich dadurch aus, daß der Taktgenerator ein gegenüber einem internen Taktgenerator der digitalen Prozessoreinrichtung eigenständiger, vom Takt dieses internen Taktgenerators vorzugsweise unabhängiger Taktgenerator ist und der erste Signalgenerator oder/und der zweite Signalgenerator oder/und der Triggersignalgenerator als gegenüber der digitalen Prozessoreinrichtung eigenständige, vom Takt des internen Taktgenerators der digitalen Prozessoreinrichtung vorzugsweise unabhängige Generatoranordnung realisiert sind. In diesem Fall ist die digitale Prozessoreinrichtung von wesentlichen Teilen der mit der Erzeugung der Signale verbundenen Datenverarbeitung entlastet, so daß die digitale Prozessoreinrichtung ggf. auch weniger leistungsfähig sein kann. Selbstverständlich können wie bei der erstgenannten Ausführungsform auch parallel arbeitende Prozessoren oder/und wenigstens ein Hochgeschwindigkeitssignalprozessor oder/und Spezialhardware eingesetzt werden.

Die Erfindung betrifft ferner ein Verfahren, insbesondere Frequenzganganalyseverfahren, zum Messen wenigstens einer sich auf eine Frequenz beziehenden Eigenschaft eines zu untersuchenden Systems, insbesondere zum Messen der Reaktion des zu untersuchenden Systems auf wenigstens ein periodisches Treibersignal fester oder variabler Frequenz.

Ein wesentlicher Punkt der Erfindung bzw. von Weiterbildungen der Erfindung basiert auf der Bereitstellung von zwei bzw. drei Frequenzen für Treibersignal und Lokaloszillatorsignal bzw. für Treibersignal und Triggersignal bzw. für Treibersignal, Lokaloszillatorsignal und Triggersignal jeweils mit exakt definierten Frequenz- und Phasenbeziehungen, die vorzugsweise quasi-kontinuierlich einstellbar sind. Unter diesen Voraussetzungen ist es möglich, einen Analysator, insbesondere Frequenzganganalysator (ggf. Ein-Kanal-Frequenzganganalysator, vorzugsweise aber Zwei- oder Mehr-Kanal-Frequenzganganalysator), bereitzustellen, der im Vergleich zu Realisierungen des Standes der Technik wesentliche Vorteile bietet. So ist ein Betrieb über einen weiten Frequenzbereich insbesondere oberhalb der halben Abtastfrequenz der Analog-zu-Digital-Wandler-Anordnung möglicht. Dies wird erreicht durch Mischung mit dem Lokaloszillatorsignal oder/und durch Unterabtastung über mehrere Perioden ohne Mischung.

Ferner wird eine hohe Genauigkeit erreicht. Hierzu trägt besonders die erfindungsgemäß mögliche exakte Synchronisierung der Abtastfrequenz mit dem Eingangssignal zur Analog-zu-Digital-Wandler-Anordnung bei.

Die Einstellbarkeit der Frequenz mit hoher Variabilität (ggf. beliebige bzw. quasi-kontinuierliche Einstellbarkeit der Frequenzen) ermöglicht eine Vielzahl von verschiedenen Betriebs- und Analysezuständen. Beispielsweise können Basisband-Fourierkomponenten auf der Grundlage von durch direkte Abtastung erhaltenen Abtastwerten bestimmt werden. Ferner ist es möglich, die Basisband-Fourierkomponenten durch Abtastung eines Signals zu erhalten, das durch Mischen des Systemausgangssignals mit dem Lokaloszillatorsignal erzeugt wird. Eine weitere Möglichkeit liegt darin, das Systemausgangssignal (oder/und das durch Mischung erzeugte Mischungssignal) über mehrere Perioden gemäß einem Unterabtastungsschema abzutasten. Das für die Basisband-Fourierkomponenten Gesagte gilt entsprechend für höhere Fourierkomponenten, sofern diese von Interesse sind.

Die für die Frequenzganganalyse erforderliche digitale Rechenleistung kann dadurch relativ kleingehalten werden, daß die genannten Generatoren als eigenständige Einheiten, vorzugsweise digitale Einheiten, realisiert werden, so daß die digitale Prozessoranordnung von Datenverarbeitungsaufwand zur Bereitstellung der verschiedenen Frequenzen bzw Signale entlastet ist. Ferner kann die erforderliche Digitalrechenleistung dadurch kleingehalten werden, daß eine Beschränkung der Abtastfrequenzen auf den 10 kHz Bereich erfolgt.

Ein weiterer Punkt ist, daß der Analysator, insbesondere Frequenzganganalysator, strukturell einfach realisiert werden kann bzw. daß die Lehre der Erfindung und ihrer Weiterbildungen einen vergleichsweise einfachen strukturellen Aufbau des erfindungsgemäßen Analysators impliziert. So ist zusätzlich zu der Generatoranordnung zur Erzeugung der genannten Frequenzen nur ein Standard-Signalverarbeitungssystem erforderlich.

Auch das Vorsehen verschiedener Betriebszustände führt nicht zwingend zu einer komplizierteren Struktur des Analysators, da die Einstellung der Betriebszustände einfach durch entsprechende digitale Wahl der verschiedenen Frequenzen zueinander und durch entsprechende digitale Verarbeitung der Abtastwerte erfolgen kann.

In Abweichung von den vorangehenden Ausführungen kann anstelle des das periodische Treibersignal bereitstellenden, einen Teil des Analysators darstellenden ersten Signalgenerators eine externe Frequenzquelle verwendet werden, die ein Signal mit einer festen oder variablen Frequenz bereitstellt, das dem zu untersuchenden System zugeführt wird oder dem zu untersuchenden System auf andere Weise zugeordnet ist. So kann es sein, daß einfach ein externer Signalgenerator verwendet wird, der ein periodisches Treibersignal mit einer festen oder variablen Treibersignalfrequenz bereitstellt, die dem zu untersuchenden System zugeführt wird. Eine andere Möglichkeit ist, daß die Frequenzquelle Bestandteil des zu untersuchenden Systems ist.

Um eine Frequenzanalyse, ggf. Frequenzganganalyse, in bezug auf die Frequenz der Frequenzquelle durchzuführen, wird vorgeschlagen, daß das Taktsignal des Taktgenerators des Analysators, ggf. Frequenzganganalysators, mit der Frequenz der Frequenzquelle synchronisiert oder synchronisierbar ist. Für den Taktgenerator wird speziell vorgeschlagen, daß dieser auf Grundlage eines empfangenen Signals mit fester oder variabler Signalfrequenz ein periodisches Taktsignal mit einer Taktfrequenz bereitstellt, die mit der Frequenz des empfangenen Signals in einem ganzzahligen oder gebrochen-rationalen Verhältnis steht.

Die Erfindung wird im folgenden anhand von in den Figuren gezeigten Ausführungsbeispielen näher erläutert.
- Fig. 1: zeigt ein Schaltungsdiagramm eines Ausführungsbeispiels eines erfindungsgemäßen Frequenzganganalysators, der in einen ersten Betriebsmodus (Niederfrequenzbetriebsmodus) geschaltet ist.
- Fig. 2: zeigt das Schaltungsdiagramm des Frequenzganganalysators für den Fall, daß dieser in einen zweiten Betriebsmodus 2(Hochfrequenzbetriebsmodus) geschaltet ist.
- Fig. 3: zeigt schematisch ein schematisches Funktionsblockdiagramm einer digitalen Synthetisierschaltung, die zum Erzeugen einer periodischen Frequenz auf Grundlage eines der Schaltung zugeführten periodischen Taktsignals und eines in ein Register der Schaltung eingegebenen Phaseninkrements dient.
- Fig. 4: dient zur Erläuterung von den nutzbaren Frequenzbereich des Frequenzganganalysators erweiternden Varianten des Frequenzganganalysators gemäß Fig. 1 und 2.
- Fig. 5: zeigt schematisch wesentliche Teile eines weiteren Ausführungsbeispiels eines erfindungsgemäßen Frequenzganganalysators, bei dem Signalgeneratoren durch SoftwareFunktionalitäten einer digitalen Prozessoreinrichtung in Verbindung mit einer Digital-zu-Analog-Wandler-Anordnung realisiert sind.
- Fig. 6: ist ein Diagramm zur Veranschaulichung einer sog. "Unterabtastung" eines periodischen Signals mit einer Abtastfrequenz kleiner als die Hälfte der Frequenz des abgetasteten Signals.
- Fig. 7: zeigt ein dem Schaltungsdiagramm der Fig. 2 entsprechendes Schaltungsdiagramm eines Frequenzganganalysators gemäß einem weiteren Ausführungsbeispiel der Erfindung im Hochfrequenz-Betriebsmodus in Kombination mit einer externen, dem zu untersuchenden System zugeordneten Frequenzquelle.
- Fig. 8: zeigt ein Schaltungsdiagramm eines mit der Frequenz der externen Signalquelle synchronisierbaren Taktgenerator des Frequenzganganalysators der Fig. 7.

Der in den Figuren gezeigte Frequenzganganalysator 10 dient zum Messen der Reaktion eines zu untersuchenden Systems (SUT) 12 auf ein periodisches Treibersignal, im gezeigten Beispielsfall ein harmonisches Treibersignal, welches dem System zugeführt wird. Bei dem gezeigten Frequenzganganalysator handelt es sich um einen Zweikanal-Frequenzganganalysator, der es ermöglicht, vom zu untersuchenden System ein erstes und ein zweites Ausgangssignal abzugreifen, die hinsichtlich relativer Phasenlage und relativer Amplitude von Fourierkomponenten analysiert werden. Die Analyse kann allein hinsichtlich den Fourierkomponenten mit einer Frequenz gleich der Frequenz des Treibersignals erfolgen, oder auch hinsichtlich von Fourierkomponenten entsprechend höheren Harmonischen des Treibersignals.

Die Analyse erfolgt durch digitale Fouriertransformation der Ausgangssignale des SUT 12 bzw. von diese Ausgangssignale repräsentierenden, durch Herabmischen zu einer tieferen Frequenz erhaltenen Signalen. Hierzu werden die Ausgangssignale vom SUT 12 bzw. die mittels einer Mischeranordnung 14 herabgemischten Signale durch eine Analog-zu-Digital-Wandler-Anordnung (A/D-Wandler-Anordnung) 16 mit einer Abtastfrequenz abgetastet, die im Hinblick auf das Abtasttheorem auf die Frequenz der Ausgangssignale bzw. auf die Frequenz der herabgemischten Signale abgestimmt ist. Die digitalen Abtastwerte werden mittels der diskreten Fouriertransformation fouriertransformiert, um die Fourierkoeffizienten der interessierenden. Signalkomponenten und letztendlich - gemäß einem bevorzugten Anwendungsgebiet - interessierende dielektrische Größen und Impedanzgrößen eines zu analysierenden Materials zu erhalten. Im genannten Anwendungsbeispiel handelt es sich bei dem SUT 12 um eine Kondensatoranordnung mit zwischen Kondensatorplatten angeordnetem,zu analysierenden Material. Man spricht in diesem Zusammenhang von dielektrischer Spektroskopie oder/und Impedanzspektroskopie.

Um im Hinblick auf eine besonders hohe Meßgenauigkeit eine synchronisierte Abtastung vorzusehen, werden das dem SUT 12 zugeführte harmonische Treibersignal Ss, ohne Beschränkung der Allgemeinheit beispielsweise repräsentiert durch sin (ωs x t), und ein zwei A/D-Wandler 16a und 16b der A/D-Wandler-Anordnung 16 sowie einen digitalen Prozessor 20 ansteuerndes Triggersignal St von einem gemeinsamen Taktsignal Sclk abgeleitet. Hierzu steuert ein das Taktsignal Sclk mit einer Frequenz Fclk beispielsweise als Pulssignal erzeugender Taktgenerator 22 einen Sinuswellensynthesizer 24 (erster Signalgenerator 24) und einen Pulssynthesizer 26 (Triggersignalgenerator 26) an.

Der Sinuswellensynthesizer 24 erzeugt das Treibersignal Ss (Frequenz Fs, Kreisfrequenz ωs) und führt dieses über einen Tiefpaß 28 dem SUT 12 zu. Der Tiefpaß 28 dient nur dazu, hochfrequente, auf die Art der Signalerzeugung zurückgehende Störkomponenten herauszufiltern.

Der Pulssynthesizer 26 erzeugt das Triggersignal St mit einer Frequenz Ft (Kreisfrequenz ωt), das über entsprechende Leitungen einem Interrupteingang des digitalen Prozessors 20 und den A/D-Wandlern 16a und 16b zugeführt wird. Bei den A/D-Wandlern löst jeder Puls des Triggersignals St eine Analog-zu-Digital-Wandlung aus und beim digitalen Prozessor 20 löst jeder Triggersignalpuls einen Interrupt aus, der ein Datenaufnahmeunterprogramm aufruft, das den digitalen Prozessor 20 derart steuert, daß dieser über einen Datenbus 30 von den A/D-Wandlern 16a und 16b bereitgestellte digitale Ausgangswerte einliest, die einen Momentanwert eines am jeweiligen A/D-Wandler anliegenden Eingangssignals repräsentieren.

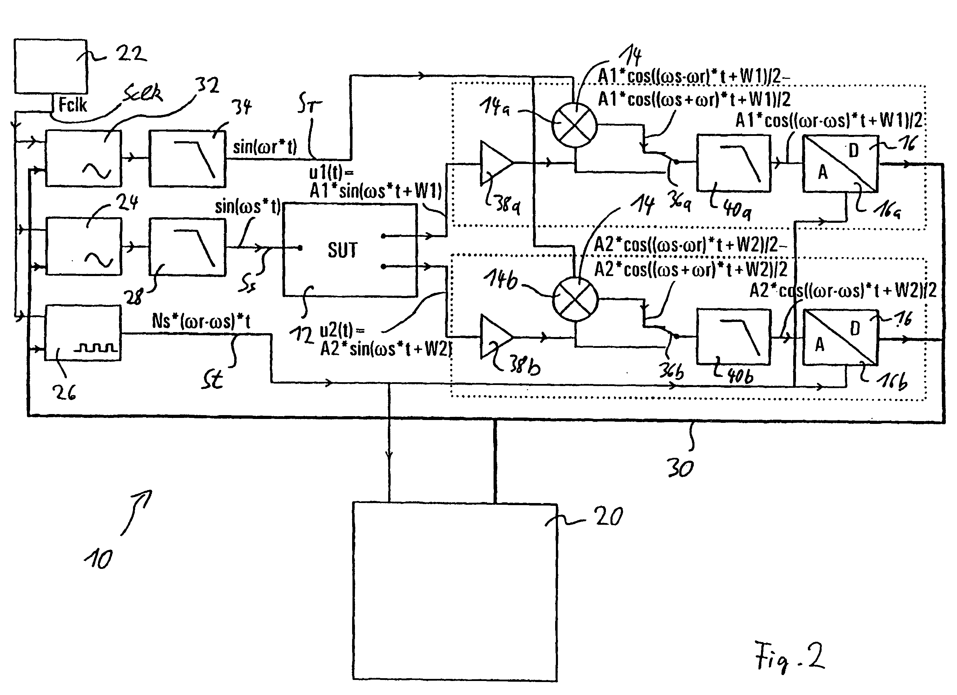

Zusätzlich zu den genannten Synthesizern ist ein weiterer Sinuswellensynthesizer 32 (zweiter Signalgenerator 32) vorgesehen, der in einem Hochfrequenzmeßmodus des Frequenzganganalysators 10 ein Lokaloszillatorsignal Sr (vgl. Fig. 2) mit einer Frequenz Fr (Kreisfrequenz ωr) erzeugt, das dazu dient, die Ausgangssignale des SUT 12 in der schon genannten Mischeranordnung 14, umfassend einen Mischer 14a und einen Mischer 14b, zu der tieferen Frequenz (Meßfrequenz) herabzumischen. Der das periodische, im vorliegenden Beispielfall harmonische Lokaloszillatorsignal Sr (ohne Beschränkung der Allgemeinheit repräsentiert durch sin (ωr x t)) erzeugende Sinuswellensynthesizer 32 wird ebenfalls vom Taktgenerator 22 angesteuert, so daß das Lokaloszillatorsignal Sr ebenfalls vom gemeinsamen Taktsignal Sclk abgeleitet wird. Das Lokaloszillatorsignal wird über einen zur Eliminierung hochfrequenter Störkomponenten dienenden Tiefpaß 34 den Mischern 14a und 14b zugeführt.

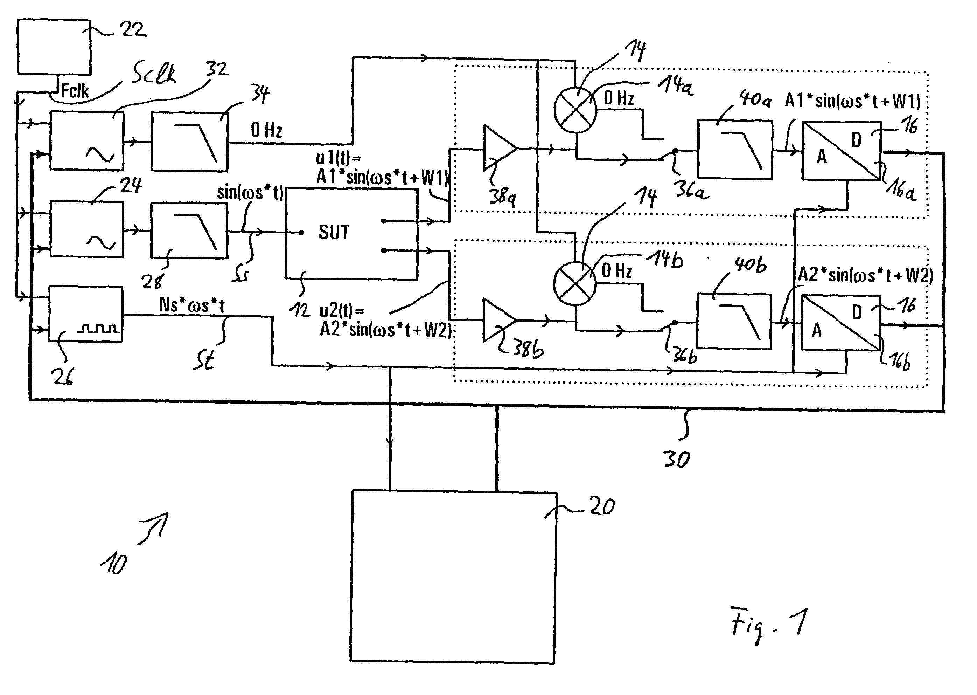

Der in Fig. 1 gezeigte Niederfrequenzmodus des Frequenzganganalysators und der in Fig. 2 gezeigten Hochfrequenzmodus des Frequenzganganalysators unterscheiden sich dadurch, daß im Niederfrequenzmodus der zum Erzeugen des Lokaloszillatorsignals dienende zweite Signalgenerator 32 nicht aktiv ist, also kein Signal abgibt. Ferner sind zwei Schalter 36a und 36b derart geschaltet, daß die über einen jeweiligen Verstärker 38a bzw. 38b dem Schalter 36a bzw. 36b zugeführten Ausgangssignal u1 (t) und u2 (t) vom SUT 12 über einen Tiefpaß 40a bzw. 40b direkt dem A/D-Wandler 16a bzw. 16b zugeführt werden. Die Mischer 14a und 14b sind dementsprechend im Hinblick auf den Signalfluß der Ausgangssignale u1 (t) und u2 (t) überbrückt und funktionslos.

Ferner ist die Frequenz Ft des Triggersignals St in bezug auf die Frequenz Fs des Treibersignals Ss im Niederfrequenzmodus derart abgestimmt, daß zwischen diesen Frequenzen ein ganzzahliges oder gebrochen-rationales Verhältnis besteht. In Fig. 1 ist davon ausgegangen, daß zwischen diesen Frequenzen ein ganzzahliges Verhältnis besteht, so daß die Kreisfrequenz ωt des Pulssignals (Triggersignals) St durch Ns x ωs gegeben ist, wobei Ns eine natürliche Zahl ist. Im Falle, daß ein gebrochen-rationales Verhältnis zwischen den genannten Frequenzen besteht, würde die Kreisfrequenz ωt des Triggersignals St durch (N₁/N₂) x ωs gegeben sein, wobei N₁ und N₂ natürliche Zahlen sind.

Im Gegensatz dazu ist im Hochfrequenzmodus der zweite Signalgenerator 32 aktiv und erzeugt das Lokaloszillatorsignal Sr, dessen Kreisfrequenz ωr beispielsweise größer als die Kreisfrequenz ωs des Treibersignals Ss sein kann, aber typischerweise in der gleichen Größenordnung liegt. Die beiden Schalter 36a und 36b sind im in Fig. 2 dargestellten Hochfrequenzmodus derart geschattet, daß die Mischer 14a und 14b in Reihe zwischen dem Verstärker 38a und dem Tiefpaß 40a bzw. zwischen dem Verstärker 38b und dem Tiefpaß 40b geschaltet sind. Die Mischer 14a und 14b empfangen also jeweils das Lokaloszillatorsignal Sr und das Ausgangssignal u1 (t) bzw. u2 (t). Im Mischer werden die beiden jeweils zugeführten Signale multipliziert, so daß am jeweiligen Mischerausgang ein Mischerausgangssignal abgegeben wird, das eine (niederfrequente) Komponente bei der Differenzfrequenz und eine (hochfrequente) Komponente bei der Summenfrequenz der multiplizierten Signale enthält. Dieses Mischerausgangssignal wird über den Schalter 36a bzw. 36b dem Tiefpaß 40a bzw. 40b zugeführt, der die hochfrequente Signalkomponente eliminiert. Der A/D-Wandler 16a bzw. 16b empfängt dementsprechend von dem Tiefpaß 40a bzw. 40b die niederfrequente Signalkomponente des Mischerausgangssignals, deren Frequenz bei der Differenzfrequenz liegt. Ausgedrückt in Kreisfrequenzen weist das vom jeweiligen A/D-Wandler empfangene Signal eine Frequenz ωr - ωs auf, wobei das Treibersignal Ss und das Lokaloszillatorsignal Sr hinsichtlich ihrer Frequenzen bevorzugt derart aufeinander abgestimmt sind, daß unabhängig von der momentanen Meßfrequenz (Frequenz ωs des Treibersignals Ss) stets die gleiche Differenzfrequenz 2π x ΔF = (ωr ωs) resultiert.

Die Frequenz Ft des Triggersignals St ist im Hochfrequenzmodus auf die Frequenz der niederfrequenten Mischerausgangssignalkomponente, also an die Differenzfrequenz ΔF, derart angepaßt, daß zwischen diesen Frequenzen ein ganzzahliges oder gebrochen-rationales Verhältnis besteht. In der Fig. 2 wurde davon ausgegangen, daß ein ganzzahliges Verhältnis besteht, so daß die Kreisfrequenz ωt des Triggersignals gleich Ns x (ωr - ωs) ist, wobei Ns eine natürliche Zahl ist. Im Falle eines gebrochen-rationalen Verhältnisses würde die Kreisfrequenz ωt des Triggersignals St gleich (N₁/N₂) x (ωr - ωs) sein, wobei N₁ und N₂ natürliche Zahlen sind.

Die den A/D-Wandlern 16a und 16b zugeführten Signale (im Niederfrequenzmodus gemäß Fig. 1 die beiden Ausgangssignale u1 (t) und u2 (t) des SUT 12 nach Verstärkung und Filterung durch die Komponenten 38a bzw. 38b und 40a bzw. 40b und im Hochfrequenzmodus gemäß Fig. 2 die Ausgangssignale der Mischer 14a und 14b nach Filterung durch die Tiefpässe 40a und 40b) werden für die jeweilige Frequenz Fs des Treibersignals Ss über mehrere Perioden des am A/D-Wandler 16a bzw. 16b anliegenden Signals abgetastet. Im Falle eines ganzzahligen Verhältnisses zwischen der Frequenz des an den A/D-Wandlern anliegenden Signals und der Frequenz des Triggersignals St werden für jede Periode phasengleiche Abtastwerte abgetastet. Im Falle eines gebrochen-rationalen Verhältnisses zwischen diesen Frequenzen ergeben sich phasengleiche Abtastwerte nach einer vorgegebenen Anzahl von Perioden der an den A/D-Wandlern anliegenden Signale.

Die abgetasteten Abtastwerte werden, wie schon erwähnt, über den Datenbus 30 der digitalen Prozessoranordnung zugeführt, die diese Abtastwerte weiter verarbeitet. Im Zuge dieser Verarbeitung innerhalb der digitalen Prozessoranordnung wird eine digitale Fouriertransformation auf den Abtastwerten bzw. auf aus den Abtastwerten durch weitere Verarbeitung gewonnenen Verarbeitungswerten durchgeführt. Im Zuge der Bestimmung der wenigstens einen, die Reaktion des Systems auf das Treibersignal charakterisierenden Größen unter Anwendung der digitalen Fouriertransformation werden beispielsweise die Phasendifferenz W1 - W2 bestimmt sowie die Amplituden A1 und A2 oder/und das Amplitudenverhältnis A1/A2 bestimmt, wobei A1 und A2 die Fourieramplituden der Basisband-Fourierkomponenten (Kreisfrequenz ωs) der Ausgangssignale u1 (t) und u1 (t) vom SUT 12 und W1 und W2 die Phase der jeweiligen Fourierkomponente relativ zum Treibersignal Ss sind. Beispielsweise ist es für die schon erwähnten Anwendungen in der Materialanalyse völlig ausreichend, ein Verhältnis der genannten Amplituden A1 und A2 sowie die relative Phase (W1 - W2) zu bestimmten, vorzugsweise als Funktion der Treibersignalfrequenz Fs über einen interessierenden Frequenzbereich.

Für den Fall, daß auch ein Absolutwert der jeweiligen Amplitude einer Fourierkomponente und deren Phase in Bezug auf das Treibersignal von Interesse sind, kann der Frequenzganganalysator in Abweichung von den Darstellungen in Fig. 1 und 2 auch als Dreikanalsystem ausgeführt sein (zum ersten Kanal zugehörig können die Komponenten 38a, 14a, 36a, 40a und 16a identifiziert werden, wohingegen zum zweiten Kanal zugehörig die Komponenten 38b, 14b, 36b, 40b und 16b identifiziert werden können), das die Analyse eines oder beider Ausgangssignale des SUT 12 relativ zum Treibersignal ermöglicht. Hierzu wäre das Treibersignal Ss oder ein hiervon abgeleitetes Signal unter Überbrückung des SUT einem zusätzlichen, analog zu dem ersten und zweiten Kanal aufgebauten dritten Meßkanal zuzuführen. Selbstverständlich kann der Frequenzganganalysator auch noch weitere Meßkanäle aufweisen.

Zu Fig. 1 ist noch nachzutragen, daß der A/D-Wandler 16a bzw. 16b ein Signal empfängt, das bis auf eine etwaige Verstärkung und Skalierung durch den Verstärker 38a bzw. 38b und Unterdrückung hochfrequenter Komponenten durch den Tiefpaß 40a bzw. 40b direkt dem Ausgangssignal u1 (t) bzw. u2 (t) vom SUT 12 entspricht. Dementsprechend ist in Fig. 1 an den betreffenden A/D-Wandler 16a bzw. 16b als Repräsentant für das Eingangssignal zum A/D-Wandler das Signal A1 x sin (ωs x t + W1) bzw. das Signal A2 x sin (ωs x t + W2) geschrieben, wobei als Repräsentant des Ausgangssignals u1 (t) = A1 x sin (ωs x t + W1) bzw. u2 (t) = A2 x sin (ωs x t + W2) in der Figur angegeben ist. In der Regel wird das Ausgangssignal des SUT aber auch Frequenzkomponenten bei Vielfachen der Treibersignalfrequenz aufweisen, die bei entsprechender Auslegung der Tiefpässe 40a und 40b ebenfalls den A/D-Wandlern 16a und 16b zugeführt werden. Ob die Abtastwerte der A/D-Wandler auch hinsichtlich dieser höheren Harmonischen analysiert werden, ist eine Frage der Abtastfrequenz Ft und der Datenverarbeitung im digitalen Prozessor 20. Für die eine bevorzugte Anwendung darstellende Materialanalyse ist es in der Regel ausreichend, nur das Verhältnis der Amplituden A1 und A2 und die Phasendifferenz W1 - W2 zu bestimmen. Es reicht also eine Analyse der Abtastwerte hinsichtlich den Fourierkomponenten im Basisband aus. Selbstverständlich können aber auch höhere Harmonische in entsprechender Weise ausgewertet werden, indem mittels der digitalen Fouriertransformation auch die relativen Amplituden und Phasen der höheren Harmonischen bestimmt werden.

Entsprechendes gilt für den Hochfrequenzmodus. In Fig. 2 ist als Repräsentant für die vom A/D-Wandler 16a bzw. 16b empfangenen Mischerausgangssignalkomponenten das Signal A1 x cos (ωr - ωs) x t + W1)/2 bzw. A2 x cos ((ωr - ωs) x t + W2)/2 eingetragen, das der niederfrequenten Mischerausgangssignalkomponente entspricht. Die hochfrequente Mischerausgangssignalkomponente A1 x cos ((ωs + ωr) x t + W1)/2 bzw. A2 x cos ((ωs + ωr) x t + W2)/2 ist, wie erläutert wurde, durch den Tiefpaß 40a bzw. 40b unterdrückt. In beiden Mischerausgangskomponenten sind die Amplitude A1 bzw. A2 und die Phase W1 bzw. W2 der Basisbandkomponente A1 x sin (ωs x t + W1) bzw. A2 x sin (ωs x t + W2) des Ausgangssignals u1 (t) bzw. u2 (t) enthalten. Bei den im Regelfall entstehenden harmonischen Komponenten der Ausgangssginale u1 (t) und u2 (t) findet bei entsprechender Auslegung des Mischers 14a bzw. 14b in analoger Weise ein Herabmischen zu tieferen Frequenzen statt, so daß bei entsprechender Auslegung der Tiefpässe 40a und 40b und der A/D-Wandler 16a und 16b auch eine Analyse der höheren Fourierkomponenten durch die im digitalen Prozessor 20 durchgeführte digitale Fouriertransformation erfolgen kann, falls dies gewünscht ist.

Sollen höhere Fourierkomponenten bestimmt werden, so läßt sich eine spezielle Auslegung der Tiefpässe 40a und 40b und der A/D-Wandler 16a und 16b für höhere Frequenzen vermeiden, indem die Lokaloszillatorsignalfrequenz Fr derart eingestellt wird, daß die interessierende Fourierkomponente bei einer bestimmten, auf die Tiefpässe und A/D-Wandler abgestimmten Differenzfrequenz auftritt. Es wird auf weitere Ausführungen hierzu weiter unten verwiesen.

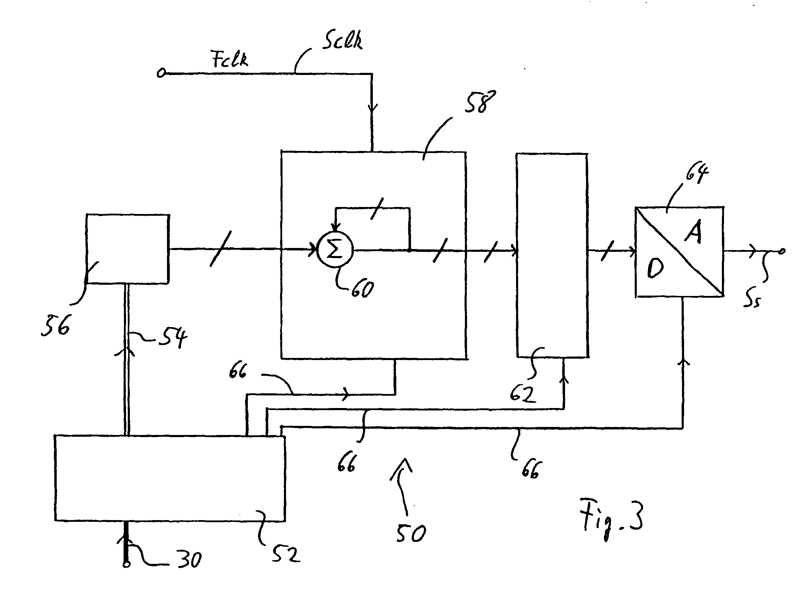

Im folgenden wird der grundlegende Aufbau der Generatoren 24, 26 und 32 gemäß einer bevorzugten Ausführungsform näher erläutert. Kernstück der Generatoren ist die in Fig. 3 schematisch und nur hinsichtlich zentraler Funktionalitäten dargestellte Generatorschaltung. Bei der folgenden Beschreibung wird davon ausgegangen, daß die in Fig. 3 gezeigte Generatorschaltung Teil des das Treibersignal Ss erzeugenden Sinuswellensynthesizers 24 (erster Signalgenerator) ist.

Die Generatorschaltung 50 umfaßt eine verschiedene Register, eine Steuerlogik und eine Busschnittstelle enthaltende Steuereinheit 52, die über den Datenbus 30 mit dem digitalen Prozessor 20 in Verbindung steht. Die Steuereinheit 52 steht über einen internen Datenbus 54 mit einem Frequenzregister 56 in Verbindung. Zur Definition der Frequenz des vom Generator abzugebenden Signals schreibt der digitale Prozessor 20 über den Bus 30, die Steuereinheit 52 und den internen Bus 54 einen 32-Bit-Phasenwert in das Register 56, der die Frequenz des Generatorausgangssignals als Bruchteil der Frequenz des der Generatorschaltung 50 zugeführten Taktsignals Fclk angibt. Genauer: Der in das Register 56 eingeschriebene Wert repräsentiert ein Phaseninkrement, um das für jeden Takt des einer Akkumulatorschaltung 58 zugeführten Taktsignals Sclk in einem Akkumulatorregister 60 der Akkumulatorschaltung 58 ein 32-Bit-Phasenwert vergrößert wird. Das Akkumulatorregister 60 ist ebenfalls ein 32-Bit-Register und enthält stets eine eine generatorinterne Phase repräsentierende 32-Bit-Integer-Zahl. Eine Phase von 2π ist dabei durch 2³² repräsentiert und das in das Frequenzregister 56 eingeschriebene bzw. einzuschreibende Phaseninkrement kann Integerwerte ≥ 0 und ≤ 2³² -1 annehmen.

Für jeden Takt des Taktsignals Sclk wird der im Akkumulatorregister 60 enthaltene, die generatorinterne Phase repräsentierende Integerwert um den im Frequenzregister 56 enthaltenen Integerwert vergrößert. Die Akkumulatorschaltung 58 erzeugt dementsprechend ein 32-Bit-Phasensignal, das einem Festwertspeicher 62 zugeführt wird. Der Festwertspeicher 62 interpretiert das ihm zugeführte Phasensignal als Adresse einer jeweiligen Speicherzelle, die einen dem Phasenwert zugeordneten Amplitudenwert enthält. In den Speicherzellen des Festwertspeichers 62 ist der Verlauf der Sinus- bzw. Cosinusfunktion als Funktion der Phase abgespeichert. Der Inhalt der momentanen Speicherzelle, die durch das dem Festwertspeicher 62 zugeführte Phasensignal adressiert ist, wird einem Digital-zu-Analog-Wandler 64 (D/A-Wandler 64) zugeführt, der eine dem momentan empfangenen Digitalwert entsprechende analoge Spannung abgibt. Entsprechend der Frequenz Fclk des-Taktsignals Sclk folgt die vom D/A-Wandler 64 abgegebene Spannung einer Sinus- bzw. Cosinusfunktion mit durch den Phaseninkrement definierter Frequenz. Dieses vom D/A-Wandler 64 abgegebene Spannungsignal ist das Treibersignal Ss, das dem zu untersuchenden System (SUT) 12 zugeführt wird. Selbstverständlich können dem D/A-Wandler noch eine Verstärkerschaltung und dergleichen zur Skalierung des Generatorausgangssignals nachgeschaltet sein. In Fig. 3 ist ferner durch Steuerleitungen 66 angedeutet, daß neben dem Frequenzregister 56 auch die anderen Komponenten der Generatorschaltung 50 über die Steuereinheit 52 ansteuerbar sein können.

Als Beispiel soll von einem 50 MHZ-Taktsignal Sclk ausgegangen werden. Für ein in das Frequenzregister 56 eingeschriebenes Phasenwort von 051EB852 Hex ergibt sich eine Frequenz des Generatorausgangssignals Ss von f = (51EB852 x 50 MHz)/2³² = 1,000000000931 MHz.

Die vorstehenden Ausführungen zur Generatorschaltung 50 des ersten Signalgenerators 24 gelten entsprechend auch für die Generatorschaltung des zweiten, das Lokaloszillatorsignal Sr abgebenden Signalgenerators 32. Ferner gelten sie auch für die Generatorschaltung des Triggersignalgenerators 26, wobei der Generatorschaltung für den Fall eines Triggerpulssignals aber noch eine das Sinussignal in ein Puls- oder Rechtecksignal umwandelnde Schaltung, beispielsweise eine Schmitt-Trigger-Schaltung oder dergleichen, nachzuschalten ist.

Aufgrund des beschriebenen Aufbaus der Generatoren 24, 26 und 32 kann der digitale Prozessor 20 ohne wesentlichen Datenverarbeitungsaufwand durch den digitalen Prozessor 20 selbst für eine Erzeugung der für die Frequenzganganalyse benötigten Signale mit an die Meßsituation angepaßten Frequenzen sorgen. Im Niederfrequenzmodus ist die Frequenz Fs des Treibersignals Ss gegeben durch Fclk x nₛ/n₀, wobei n₀ der eine Phase von 2π representierende 32-Bit-Wert 2³² ist und nₛ das 32-Bit-Phaseninkrement ist, das der digitale Prozessor 20 in das Frequenzregister 56 eingeschrieben hat.

Entsprechend gilt für die Frequenz Ft des Triggersignals St: Ft = Fclk x nₜ/n₀, wobei nₜ der vom digitalen Prozessor 20 in das Frequenzregister der Generatorschaltung des Triggersignalgenerators 26 eingeschriebene 32-Bit-Phaseninkrementwert ist. Für den Fall, daß nₜ ein ganzzahliges Vielfaches von nₛ ist, kann die Frequenz Ft auch als Ns x Fs geschrieben werden mit Ns = nₜ/nₛ.

Der Hochfrequenzmodus unterscheidet sich vom Niederfrequenzmodus dadurch, daß zusätzlich das Lokaloszillatorsignal Sr mit einer Frequenz Fr = Fclk x nᵣ/n₀ erzeugt wird, wobei n, das durch den digitalen Prozessor 20 in das Frequenzregister 56 der Generatorschaltung des zweiten Signalgenerators 32 eingeschriebene 32-Bit-Phaseninkrement ist. Für den Fall, daß die Frequenz des Triggersignals St ein ganzzahliges Vielfaches der Frequenz der den A/D-Wandlern 16a und 16b zugeführten Mischerausgangssignalkomponenten ist (Differenzfrequenz ΔF = Fr - Fs), läßt sich die Frequenz Ft schreiben als Ns x (Fr - Fs) = Fclk x (nᵣ - nₛ)/n₀.

Sollen höhere Harmonische bzw. Fourierkomponenten unter Herabmischen der Systemausgangssignale u1 (t) und u2 (t) mittels der Mischeranordnung 14 bestimmt werden, so ist es vorteilhaft, wenn in diesem Fall die Lokaloszillatorsignalfrequenz Fr auf die Frequenz der interessierenden Harmonischen n x Fs +/- ΔF eingestellt wird (n ist eine die Ordnung der Fourierkomponente angebende natürliche Zahl, wobei n = 1 für die Basiskompcnente gilt). ΔF ist die feste Differenzfrequenz an der Analog-zu-Digital-Wandler-Anordnung 16, wobei allgemein gilt ΔF = Ft/Z oder ΔF = Ft/R, wobei Z eine ganze Zahl und R eine gebrochen-rationale Zahl ist. Diese gemäß dem Weiterbildungsvorschlag feste, d. h. für alle Fourierkomponenten gleiche Differenzfrequenz kann beispielsweise 10 kHz betragen. Gemäß dem Weiterbildungsvorschlag erscheint die gesuchte n-te Fourierkomponente bei der (festen) Differenzfrequenz ΔF an der Analog-zu-Digital-Wandler-Anordnung 16. Eine Anpassung der Digital-zu-Wandler-Anordnung 16 und der Tiefpässe 40a und 40b im Hinblick auf die Bestimmung von höheren Fourierkomponenten ist deshalb nicht erforderlich. Insbesondere wird vermieden, daß die gesuchte Harmonische oberhalb der Grenzfrequenz der Analog-zu-Digital-Wandler-Anordnung erscheint. Die digitale Fouriertransformation kann unverändert, wie bei der Bestimmung von Basisband-Fourierkomponenten, auf Grundlage der Basisfrequenz ΔF durchgeführt werden.

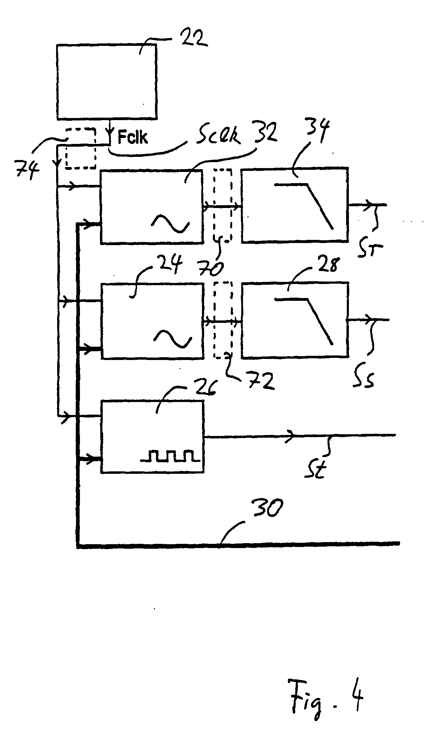

Bei dem Taktgenerator 22 kann es sich um einen Quarzkristall-Taktoszillator mit einer festen Frequenz, beispielsweise 50 MHz, handeln. Auf Grundlage des 50 MHz-Taktsignals Fclk ergibt sich beispielsweise ein nutzbarer Frequenzbereich für den ersten Signalgenerator 24 von 11,6 mHz bis 25 MHz, wobei eine Auflösung von 11,6 mHz besteht. In der Praxis wird man ggf., je nach ggf. verwendeten Anti-Aliasing-Filtern, eine obere Grenze von etwa 20 MHz für den nutzbaren Frequenzbereich haben. Die obere Grenze des nutzbaren Frequenzbereichs kann verdoppelt werden, indem man den Signalgeneratoren 24 und 32 jeweils ein Quadrierglied 70 bzw. 72 (beispielsweise ein Multiplizierglied, bei dem die beiden Eingänge miteinander verbunden sind) nachschaltet. Derartige Quadrierglieder 70, 72 sind in Fig. 4 gestrichelt angedeutet. Um ferner den nutzbaren Frequenzbereich zu tieferen Frequenzen hin zu erweitern, kann man dem Taktgenerator 22 ein Frequenzdividierglied nachschaiten. In Fig. 4 ist ein derartiges Frequenzdividierglied 74 gestrichelt angedeutet. Beispielsweise kann es sich um ein dreistufiges Dividierglied handeln, bei dem jede Stufe eine Frequenzdivision um den Faktor 16 liefert. Damit ist im betrachteten Beispielsfall eine tiefste Frequenz von 2,8 µHz mit einer Auflösung von 2,8 µHz möglich.

Bei dem beschriebenen erfindungsgemäßen Frequenzganganalysator läßt sich eine sehr große absolute Phasengenauigkeit bei einer sehr hohen Phasenauflösung insbesondere für Frequenzen unterhalb von etwa 1 MHz erreichen. Ferner läßt sich ohne weiteres eine sehr große relative Amplitudengenauigkeit bei einer sehr hohen relativen Amplitudenauflösung erreichen. Für Frequenzen oberhalb etwa 1 MHz nimmt die Phasenamplitudengenauigkeit ab, kann aber ohne weiteres noch gute Werte beispielsweise bei 40 MHz erreichen. Zu den genannten hohen Genauigkeiten trägt insbesondere die digitale Synthetisierung aller Frequenzen und deren Einstellung durch exakte Integerwerte retativ zueinander bei, wodurch sich vor allem auch ein digital exaktes Timing für den Algorithmus einer durch den digitalen Prozessor 20 durchgeführten digitalen Fouriertransformation ergibt. Da die Analog-zu-Digital-Wandler-Anordnung 16 nur bei niedrigen Frequenzen betrieben werden muß (beispielsweise kleiner als 1 KHz im Niederfrequenzmodus und beispielsweise eine feste Differenzfrequenz etwa bei 70 Hz im Hochfrequenzmodus), können hochauflösende A/D-Wandler, beispielsweise mit einer Auflösung von 16 Bit oder größer) verwendet werden. Da die Betriebsfrequenzen weit unterhalb der (einstellbaren) Abtastfrequenz der A/D-Wandler (beispielsweise etwa 100 KHz) liegen können, kann ein sogenanntes "Oversampling" (Überabtastung) erreicht werden, was eine besonders hohe Genauigkeit ergibt.

Die beim beschriebenen Ausführungsbeispiel vorgesehene Aufteilung des gesamten Meßbereichs auf Hochfrequenzmodus und Niederfrequenzmodus ist prinzipiell beliebig; im gezeigten Ausführungsbeispiel der Fig. 1 bis 4 entsprechen Treibersignalfrequenzen Fs dem Niederfrequenzmodus und entsprechen Treibersignalfrequenzen ≥ 1 KHz dem Hochfrequenzmodus. Trotz der genannten hohen Genauigkeit und Auflösung ist der Frequenzganganalysator strukturell einfach und aus kostengünstig erhältlichen Komponenten aufgebaut, so daß sich vergleichsweise geringe Herstellungskosten ergeben. Zur strukturellen Einfachheit trägt insbesondere bei, daß alle Frequenzen ausgehend vom Taktsignal durch gesonderte Generatoren erzeugt werden, die selbsttätig ihr jeweiliges Signal erzeugen gemäß eines vom digitalen Prozessor 20 übermittelten Steuerbefehls, der gemäß dem gezeigten Ausführungsbeispiel durch Einschreiben des Phaseninkrements in das Frequenzregister die Frequenz des jeweiligen Generatorausgangssignals anweist. Der digitale Prozessor 20 schaltet gemäß der Weiterbildung der Fig. 4 zusätzlich die Frequenzquadrierglieder 70 und 72 bzw. das Frequenzdividierglied 74 zu, um im Hochfrequenzmodus höhere Frequenzen zu erreichen (Zuschaltung der Quadrierglieder 70, 72) bzw. um im Niederfrequenzmodus tiefere Frequenzen zu erreichen (Zuschaltung des Frequenzdividierglieds 74).

Bei dem Ausführungsbeispiel der Fig. 1 und 3 und der Ausführungsvariante der Fig. 4 sind die Signalgeneratoren 24, 26 und 32 gegenüber dem digitalen Prozessor 20 eigenständige Generatoren, die von diesem nur die zu erzeugenden Frequenzen in Bezug auf die Taktsignalfrequenz Fclk angewiesen bekommen. Die Generatoren erzeugen ihre Signale auf Grundlage des Taktsignals Fclk vom Taktgenerator 22, der ein vom digitalen Prozessor 20 unabhängiger (gesonderter) Taktgenerator sein kann. Zwar ist es denkbar, daß die Generatoren 24, 26 und 32 als Grundlage für ihre Signalerzeugung ein internes Taktsignal des digitalen Prozessors 20 empfangen (in diesem Fall wäre der Taktgenerator 22 als interner Taktgenerator des digitalen Prozessors 20 zu identifizieren). Es wird hier aber davon ausgegangen, daß es sich bei dem Taktgenerator 22 um einen gesonderten Generator handelt, der von einem internen Takt des Prozessors unabhängig und mit diesem nicht synchronisiert ist.

Durch die Ausbildung des Frequenzganganalysators mit gegenüber dem digitalen Prozessor eigenständigen Signalgeneratoren wird der digitale Prozessor 20 von Datenverarbeitungsaufwand für die Bereitstellung der benötigten Signale entlastet.

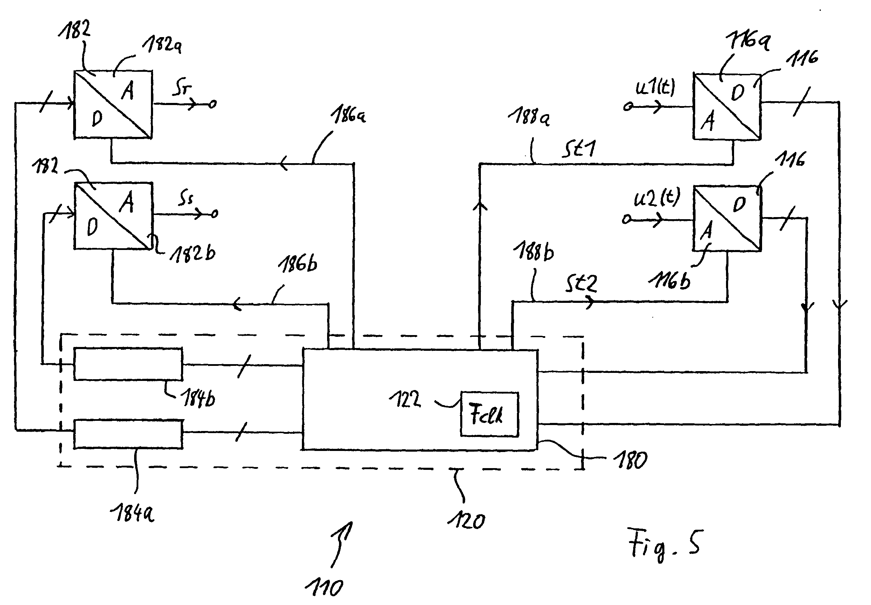

Es ist aber auch denkbar, den Frequenzganganalysator im wesentlichen softwaremäßig, also durch Softwarefunktionalitäten einer digitalen Prozessoreinrichtung zu realisieren. Es wird hierzu auf das in Fig. 5 gezeigte Ausführungsbeispiel verwiesen. Es werden hier nur die Unterschiede zum Ausführungsbeispiel der Fig. 1 bis 3 erläutert, wobei für gleiche oder analoge, insbesondere funktionsmäßig. analoge Komponenten bzw. Funktionalitäten die gleichen Bezugszeichen, jeweils um 100 vermehrt, verwendet werden.

Der Frequenzganganalysator 110 der Fig. 5 umfaßt einen digitalen Prozessor 120, der eine Prozessor-Takt- und Speicheranordnung 180 mit einem internen Taktgenerator 122 umfaßt. Die Anordnung 180 berechnet oder bestimmt die auszugebenden Signalamplituden als Funktion der Zeit und schreibt die einem jeweiligen Wandelvorgang von D/A-Wandlern 182a und 182b einer Digital-zu-Analog-Wandler-Anordnung 182 zugeordneten digitalen Amplitudenwerte in Register 184a und 184b, von wo aus die Amplitudenwerte den D/A-Wandlern 182a und 182b zugeführt werden. Der digitale Prozessor 120 steht über Triggersignalleitungen 186a und 186b mit den D/A-Wandlern 182a und 182b und über Triggersignalleitungen 188a und 188b mit den A/D-Wandlern 116a und 116b in Verbindung. Durch entsprechende Ausgabe von Triggerimpulsen steuert (triggert) der digitale Prozessor 120 die Wandlung der Wandler 182a, 182b bzw. der Wandler 116a, 116b, so daß die Wandler 182a, 182b einen Analogwert entsprechend dem Inhalt der Register 184a und 184b ausgeben und die Wandler 116a und 116b die ihnen zugeführten analogen Eingangssignale, beispielsweise die Signale u1 (t) und u2 (t), wandeln und einen jeweiligen Abtastwert in digitaler Form dem digitalen Prozessor 120 zuführen.

Im Einzelnen: Der interne Taktgenerator 122 gibt ein internes Taktsignal mit einer Frequenz Fclk ab, das als Analogon des Taktsignals Sclk des Ausführungsbeispiels der Fig. 1 bis 4 angesehen werden kann und auf dessen Grundlage die D/A-Wandler 182a, 182b und - von besonderer Wichtigkeit - die A/D-Wandler 116a, 116b zur Bestimmung der Wandel- bzw. Abtastzeitpunkte über die Leitungen 186a, 186b bzw. 188a, 188b getriggert werden. Der digitale Prozessor 120 sorgt für definierte Frequenzund Phasenbeziehungen zwischen den Signale Sr und Ss einerseits und der Triggerung der A/D-Wandler 116a, 116b andererseits, wobei man die durch die Leitungen 188a und 188b geführten Triggersignale als Triggersignale im Sinne des vom Generator 26 abgegebenen Signals St des Ausführungsbeispiels der Fig. 1 bis 4 identifizieren kann.

Es ist nicht zwingend, daß beide A/D-Wandler 116a und 116b zeitgleich getriggert werden, beispielsweise könnten die beiden A/D-Wandier zeitlich versetzt mit exakt definierter Frequenz- und Phasenbeziehung zwischen den durch die Leitungen 188a, 188b geführten Triggersignalen getriggert werden. In Fig. 5 wurde von diesem allgemeinen Fall ausgegangen, so daß die Leitung 188a ein Triggersignal St1 und die Leitung 188b ein Triggersignal St2 führt. In der Regel werden die Signale St1 und St2 aber identisch sein, so daß beide A/D-Wandler 116a und 116b zeitgleich getriggert werden.

Die Signale St1 und St2 können beispielsweise von einem Zeitglied (Timer) stammen, das auf Grundlage des vom Taktgenerator 122 erzeugten Taktsignals läuft. Dieses Timersignal, das direkt einem Triggersignal Ft = St1 = St2 entsprechen könnte, kann vorteilhaft einen Prozessorinterupt auslösen, der eine die digitalen Ausgangswerte der A/D-Wandler 116a, 116b aufnehmende Dateneingaberoutine aufruft.

Auch die Ansteuerung der D/A-Wandler 182a und 182b hinsichtlich des Einschreibens von zu wandelnden Digitalwerten in die Register 184a, 184b oder/und hinsichtlich der Triggerung der D/A-Wandler 182a, 182b kann Interupt-gesteuert sein, so daß eine gute Ausnutzung der Prozessorleistung des Prozessors 120 erreicht wird, der quasi-parallel die Auswertung der von den A/D-Wandlern 116a, 116b zugeführten Digitalwerte, also digitale Fouriertransformation, ggf. der Fouriertransformation vorgeschaltete Vorverarbeitung usw., durchführt.

Unabhängig davon, ob eine Interuptsteuerung vorgesehen ist oder nicht, kann ohne weiteres eine synchrone Ansteuerung der D/A-Wandler einerseits hinsichtlich der von ihnen abgegebenen Frequenzen und der A/D-Wandler andererseits hinsichtlich der Abtastpunkte erreicht werden, beispielsweise durch synchrone Programmierung innerhalb einer gemeinsamen Programmschleife im vorzugsweise einen Signalprozessor umfassenden digitalen Prozessor 120.

Zu erwähnen ist noch, daß in Fig. 5 vom Frequenzganganalysator 110 nur die zentralen, sich auf die digitale Datenverarbeitung und die D/A-Wandlung und A/D-Wandlung beziehenden Komponenten gezeigt sind, nicht aber die zur Signalbehandlung (Filterung, Verstärkung) und Signalmischung beziehenden Komponenten; den Filtern 28, 34, 40a, 40b, den Verstärkern 38a, 38b, den Mischern 14a, 14b und den Schaltern 36a, 36b entsprechende Komponenten sind also ebenso wie das zu untersuchende System (SUT) nicht dargestellt.

Erwähnenswert ist noch, daß anstelle einer Berechnung des zeitlichen Verlaufs der von den D/A-Wandlern abzugebenden Signale, wie beim ersten Ausführungsbeispiel in der Regel Sinus- oder Cosinus-Signale, mit Durchführung von Gleitoperationen (insbesondere trigonometrische Berechnungen), wie sie beim Analysator der Fig. 5 vorgesehen ist, zur Reduzierung des Rechenaufwands des digitalen Prozessors der zeitliche Verlauf der Signale auch in einem Festwertspeicher abgelegt sein kann oder ggf. bei der Initialisierung des Systems einmal berechnet und dann für den weiteren Betrieb abgespeichert werden kann, so daß zur Ausgabe der Signale Ss und Sr keine weiteren Berechnungen dieser Art mehr erforderlich sind. Ein im wesentlichen digital aufgebauter Frequenzganganalysator kann insofern vollständig dem Frequenzganganalysator der Fig. 1 bis 3 entsprechen. Betrachtet man Fig. 3, so könnten die Komponenten 52, 56, 58 (mit 60) und 62 als Softwarefunktionalitäten oder/und Hardware-Bestandteile einer entsprechenden digitalen Prozessoreinrichtung identifiziert werden.

Die bisher beschriebenen Ausführungsbeispiele zeichnen sich durch die Mischeranordnung zum Herabmischen der Systemausgangssignale vom SUT aus, um einen Hochfrequenzmodus für das Messen bei hoher Treibersignalfrequenzen Fs vorzusehen.

Hohe Frequenzen können aber auch ohne ein Herabmischen der Systemausgangssignale erfaßt werden, indem die Systemausgangssignale nach einem sog. "Unterabtastungsschema" abgetastet werden. Ein erfindungsgemäßer Frequenzganganalysator braucht also nichtzwingend eine Mischeranordnung zum Herabmischen der Systemausgangssignale für hohe Treibersignalfrequenzen aufweisen; es ist aber denkbar, einen Frequenzganganalysator mit einer Mischeranordnung auszubilden, bei dem alternativ zum Herabmischen auch eine Messung im hohen Frequenzbereich durch das genannte, im folgenden näher zu beschreibende "Unterabtastungsschema" möglich ist. Man kann auch daran denken, eine Unterabtastung bei niedrigen Meßfrequenzen vorzusehen (also eine Unterabtastung der Systemausgangssignale u1 (t) und u2 (t) im Niederfrequenzmodus) oder/und eine Unterabtastung von mittels der Mischer herabgemischten Signale im Hochfrequenzmodus (Unterabtastung der den A/D-Wandlern zugeführten Komponenten der Mischerausgangssignale).

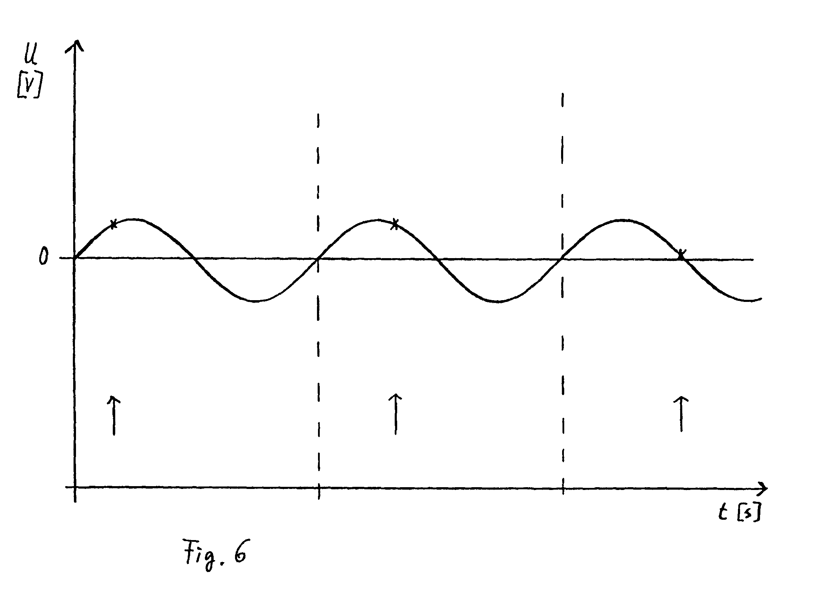

Bei einer Unterabtastung wird das jeweilige Eingangssignal zu dem A/D-Wandler 16a, 16b, 116a bzw. 116b mit einer Abtastfrequenz beispielsweise kleiner als die Hälfte der Frequenz dieses Eingangssignals abgetastet, so daß das Abtasttheorem nicht erfüllt ist. Dies fordert an sich eine Abtastung mit einer Frequenz Ft wenigstens gleich dem Doppelten der Treibersignalfrequenz Fs. Beispielsweise könnte pro Periode nur ein Abtastpunkt vorgesehen sein, wie dies in Fig. 6 veranschaulicht ist. Hier sind Abtastpunkte durch ein Kreuz an der Sinuskurve und durch Pfeile gekennzeichnet. In verschiedenen, aufeinanderfolgenden Perioden wird bei unterschiedlichen Phasenwinkeln abgetastet, so daß nach Abtastung einer vorgegebenen, von der Signalfrequenz und der Abtastfrequenz abhängigen Anzahl von aufeinanderfolgenden Perioden nach Abbildung aller Abtastpunkte in eine Periode eine für die Rekonstruktion des Signals ausreichende Abtastpunktdichte erreicht wird, nämlich eine Abtastpunktdichte, die einer direkten Abtastung unter Erfüllung des Abtasttheorems entspricht. Selbstverständlich kann man in Abweichung von Fig. 6 auch mehrere Abtastpunkte pro Periode vorsehen oder eine derart niedrige Abtastfrequenz in bezug auf die Signalfrequenz, daß nur jede x-te Periode abgetastet wird.

Das beschriebene "Unterabtastungsschema" wird nur dadurch möglich, daß die erfindungsgemäßen Frequenzganganalysatoren eine exakt definierte Frequenz- und Phasenbeziehung zwischen Treibersignal einerseits und Triggersignal andererseits bzw. allgemein eine exakt definierte Frequenz- und Phasenbeziehungen zwischen Treibersignal, Lokaloszillatorsignal und Triggersignal gewährleisten mit hoher Variabilität der einstellbaren Frequenz- und Phasenbeziehungen, insbesondere einer quasi-kontinuierlichen Einstellbarkeit.

Generell ist noch nachzutragen, daß viele Möglichkeiten existieren, die innerhalb des Frequenzganganalysators bzw. zur Ansteuerung des SUT benötigten Signale zu erzeugen. Ein Beispiel ist das oben anhand der Fig. 3 erläuterte Phaseninkrementverfahren. Eine andere Möglichkeit ist es, eine digitale Division einer Taktfrequenz vorzusehen. Entsprechende Generatoren können auch durch sog. PLL-Schaltungen (Phase-Locked-Loops) realisiert werden (man spricht von "indirekter Frequenzsynthese"). Die PLL-Schaltungen könnten beispielsweise ein gemeinsames Taktsignal zu anderen Frequenzen, in der Regel zu höheren Frequenzen, transformieren. Man kann derartige PLL-Schaltungen im Falle der Ausführungsvariante der Fig. 4 auch anstelle der Glieder 70, 72 und 74 vorsehen. Die PLL-Schaltungen können digital ansteuerbare Teilerschaltungen (insbesondere digitale Teilerschaltungen) oder/und digital ansteuerbare Multiplizierschaltungen (insbesondere digitale Multiplizierschaltungen) umfassen, über die der digitale Prozessor den Frequenztransformationsfaktor (Multiplikationsfaktor bzw. Divisionsfaktor) einstellt.

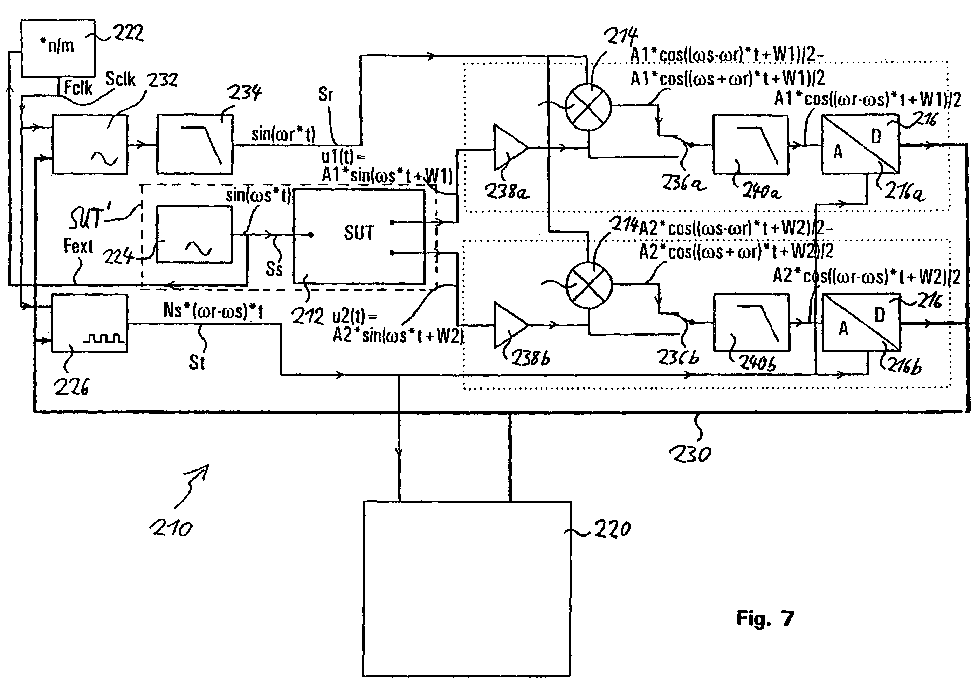

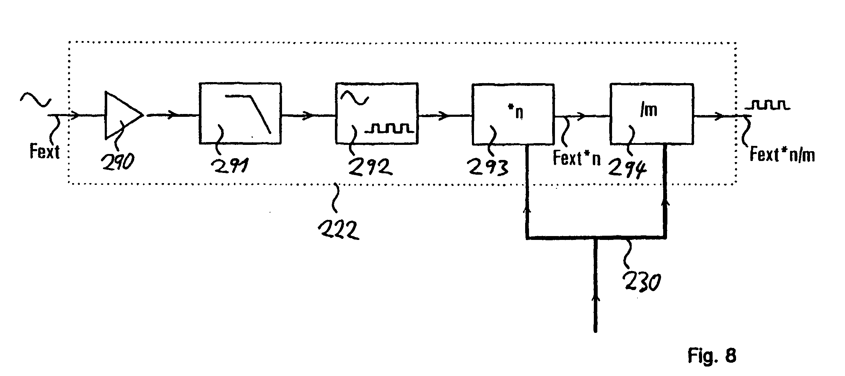

Der erfindungsgemäße Frequenzganganalysator kann auch dafür ausgelegt sein, Systeme mit extern vorgegebener Frequenz zu analysieren bzw. hinsichtlich ihrem Frequenzverhalten zu vermessen. Für derartige Anwendungen ist es an sich nicht zwingend, daß der Frequenzganganalysator eine dem Sinuswellensynthesizer 24 entsprechende, das Treibersignal Ss erzeugende Frequenzquelle aufweist. Ein Frequenzganganalysator ohne Frequenzquelle zum Erzeugen eines Treibersignals ist in den Fig. 7 und 8 gezeigt. Der in Anspruch 1 definierte Analysator umfasst allerdings einen als Frequenzquelle dienenden Signalgenerator (erster Signalgenerator), der zum Bereitstellen eines als Treibersignal verwendbaren Signals (erstes Signal) dient. Insoweit dienen die Fig. 7 und 8 nur zur Erläuterung einer bevorzugten Weiterbildung eines erfindungsgemäßen Analysators.

Bei der in Fig. 7 veranschaulichten Anwendung des erfindungsgemäßen Frequenzganganaslysators ist das bei den Meßsituationen gemäß Fig. 1 bis 6 durch den internen Signalgenerator 24 bzw. über den D/A-Wandler 182 erzeugte Treibersignal Ss durch ein externes Signal Ss ersetzt, das durch eine gegenüber dem Frequenzganganalysator externe Frequenzquelle 224 erzeugt wird. Die externe Frequenzquelle 224 kann Bestandteil des zu untersuchenden Systems (gestrichelt angedeutetes zu untersuchendes System SUT' in Fig. 7) sein. Die externe Frequenzquelle kann aber auch eine gesonderte unabhängige Frequenzquelle- 224 sein, deren Signal in das zu untersuchende System (zu untersuchendes System SUT in Fig. 7) eingespeist wird. Die Messung der die Reaktion des Systems beschreibenden Ausgangssignale u1 (t) und u2 (t) (im allgemeinen wenigstens eines Ausgangssignals u (t) des Systems) kann wie oben in bezug auf die Ausführungsbeispiele der Fig. 1 bis 6 erläutert verlaufen.

Fig. 7 zeigt einen vom Frequenzganganalysator und der externen Frequenzquelle 224 gebildelten Meß- oder Analyseaufbau für den Hochfrequenz-Betriebsmodus. Ein entsprechendes Diagramm für die Niederfrequenz-Betriebsart läßt sich aus Fig. 7 ohne weiteres entsprechend Fig. 1 ableiten.

Um die Messung in entsprechender Weise wie bei den Meßsituationen der Fig. 1 bis 6 durchführen zu können, ist der Taktgenerator 222 auf die Frequenz Fext der externen Frequenzquelle 224 synchronisierbar. Der Taktgenerator 222 ist hierzu derart aufgebaut, daß er ein Taktsignal Sclk mit einer Frequenz Fclk liefert, die mit der Frequenz Fext der externen Frequenzquelle 224 in einem ganzzahligen oder gebrochen-rationalen Verhältnis steht. Da der Frequenzganganalysator 210 ansonsten wie der Frequenzganganalysator der Fig. 1 und 2 aufgebaut ist (es sind die gleichen Bezugszeichen für identische bzw. analoge Komponenten verwendet, jeweils um 200 erhöht), wird auf diese Weise erreicht, daß auch die Frequenzen des Triggersignals St und des Lokaloszillatorsignals Sr mit der Frequenz Fext synchron sind.

Ein Beispiel, wie der Taktgenerator 222 zum Vorsehen der beschriebenen Synchronisierbarkeit aufgebaut sein könnte, ist in Fig. 8 gezeigt. Die dem Taktgenerator 222 zugeführte Frequenz Fext durchläuft gemäß Fig. 8 zuerst eine Verstärkerstufe 290 und eine Filterstufe 291. Das dann vorliegende Signal wird in einer Stufe 292, beispielsweise eine Schmitt-Trigger-Schattung, in ein Rechtecksignal mit der Frequenz Fext umgewandelt. Das Rechtecksignal wird dann z. B. mittels einer phasengeregelten Frequenzvervielfachungsschleife (Phase Locked Loop (PLL)) 293 gemäß einem ganzzahligen Faktor n vervielfacht. In einer folgenden Teilerstufe 294 wird das Signal mit der Frequenz Fext x n entsprechend einem ganzzahligen Teilefaktor m heruntergeteilt, so daß eine Taktsignalfrequenz Fclk = Fext x n/m resultiert. Die Schaltung kann dafür ausgelegt sein, daß die Faktoren n, m über den Steuerbus 230 von der Prozessoreinrichtung 220 variabel vorgegeben werden können. Für viele Zwecke wird es ausreichen, wenn der Taktgenerator 222 nur eine Frequenzvervielfachungsanordnung, ggf. Frequenzvervielfachungsschleife, aufweist. Die Verstärker-, Filter-Rechteckwandler- und Teilerstufe sind also keine zwingenden Bestandteile des Taktgenerators.

Hinsichtlich des übrigen Aufbaus und der übrigen Funktionsweise des Frequenzganganalysators 210 kann auf die vorangehende Beschreibung des Frequenzganganalysators 10 der Fig. 1 und 2 verwiesen werden.

## Patentansprüche

1. Analysator, ggf. Frequenzganganalysator, zum Messen wenigstens einer sich auf eine Frequenz beziehenden Eigenschaft eines zu untersuchenden Systems, ggf. der Reaktion des zu untersuchenden Systems auf wenigstens ein periodisches Treibersignal (Ss) fester oder variabler Frequenz (Fext), umfassend:
- einen Taktgenerator (22; 122; 222), der dafür ausgelegt ist, ein periodisches Taktsignal (Sclk) mit einer Taktfrequenz (Fclk) bereitzustellen;
- einen ersten Signalgenerator (24), der dafür ausgelegt ist, auf Grundlage des Taktsignals ein periodisches, als Treibersignal verwendbares erstes Signal (Ss) mit einer variablen ersten Signalfrequenz (Fs) bereitzustellen, die mit der Taktsignalfrequenz (Fclk) in einem ganzzahligen oder gebrochen-rationaten Verhältnis steht;
- einen weiteren Signalgenerator (32; 232; 26; 226), der dafür ausgelegt ist, auf Grundlage des Taktsignals ein periodisches, als Lokaloszillatorsignal oder Triggersignal verwendbares weiteres Signal (Sr; St) mit einer vorzugsweise variablen weiteren Signalfrequenz (Fr; Ft) bereitzustellen, die mit der Taktsignalfrequenz (Fclk) in einem ganzzahligen oder gebrochen-rationalen Verhältnis steht;
- Übertragungsmittel zum Übertragen des ersten Signals zu einem zu untersuchenden System (SUT);
- Empfangsmittel zum Empfangen wenigstens eines Ausgangssignals (u1, u2) von dem zu untersuchenden System (SUT);
- eine das weitere Signal und wenigstens ein Systemausgangssignal empfangende Mischer- oder Abtastanordnung (14, 16; 16; 116; 214, 216; 216);
- eine der Mischer- oder Abtastanordnung (14, 16; 16; 116; 214, 216; 216) zugeordnete Analog-zu-Digital-Wandler-Anordnung (16; 116; 216), die dafür ausgelegt ist, auf Grundlage eines für das Systemausgangssignal repräsentativen oder diesem entsprechenden Eingangssignals den zeitlichen Verlauf des Eingangssignals repräsentierende digitale Abtastwerte bereitzustellen,
wobei wenigstens eine Komponente des Ausgangssignals der Mischer- oder Abtastanordnung (14, 16; 16; 116; 214, 216; 216) der Analog-zu-Digital-Wandler-Anordnung (16; 116; 216) als Eingangssignal zuführbar ist;
- eine digitale Prozessoreinrichtung (20; 120; 220), die dafür ausgelegt ist, auf der Grundlage der Abtastwerte wenigstens eine die Eigenschaft, ggf. die Reaktion des Systems auf das Treibersignal, charakterisierende Größe zu bestimmen.

2. Analysator nach Anspruch 1, **dadurch gekennzeichnet, dass** der weitere Signalgenerator als Triggersignalgenerator (26; 226) dient, der dafür ausgelegt ist, auf Grundlage des Taktsignals ein periodisches Triggersignal (St) mit einer einstellbaren Triggersignalfrequenz (Ft) bereitzustellen, die mit der Taktsignalfrequenz (Fclk) in einem ganzzahligen oder gebrochen-rationalen Verhältnis steht;
wobei die Abtastanordnung in Verbindung mit der Analog-zu-Digital-Wandler-Anordnung (16; 116; 216) durch das Triggersignal (St) triggerbar ist, das Eingangssignal an durch das Triggersignal bestimmten Zeitpunkten abzutasten und entsprechende digitale Abtastwerte bereitzustellen.

3. Analysator nach Anspruch 1, **dadurch gekennzeichnet, dass** der weitere Signalgenerator als Lokaloszillatorsignalgenerator (32; 232) dient, der dafür ausgelegt ist, auf Grundlage des Taktsignals ein periodisches Lokaloszillatorsignal (Sr) mit einer vorzugsweise variablen Lokaloszillatorsignalfrequenz (Fr) bereitzustellen, die mit der Taktsignalfrequenz (Fclk) in einem ganzzahligen oder gebrochen-rationalen Verhältnis steht, wobei die das Lokaloszillatorsignal empfangende Mischeranordnung (14; 214) zum Herabmischen des Systemausgangssignals zu einer gegenüber dem Systemausgangssignal niedrigeren Frequenz dient, wobei eine Komponente des Mischeranordnungsausgangssignals mit der niedrigeren Frequenz der Analog-zu-Digital-Wandler-Anordnung (16; 116; 216) als für das Systemausgangssignal repräsentatives Eingangssignal zuführbar ist.

4. Analysator, ggf. Frequenzganganalysator, zum Messen wenigstens einer sich auf eine Frequenz beziehenden Eigenschaft eines zu untersuchenden Systems, ggf. der Reaktion des zu untersuchenden Systems auf wenigstens ein periodisches Treibersignal (Ss) fester oder variabler Frequenz (Fext), umfassend:
- einen Taktgenerator (22; 122; 222), der dafür ausgelegt ist, ein periodisches Taktsignal (Sclk) mit einer Taktfrequenz (Fclk) bereitzustellen;
- einen ersten Signalgenerator (24), der dafür ausgelegt ist, auf Grundlage des Taktsignals ein periodisches, als Treibersignal verwendbares erstes Signal (Ss) mit einer variablen ersten Signalfrequenz (Fs) bereitzustellen, die mit der Taktsignalfrequenz (Fclk) in einem ganzzahligen oder gebrochen-rationalen Verhältnis steht;
- einen zweiten Signalgenerator (32; 232), der dafür ausgelegt ist, auf Grundlage des Taktsignals ein periodisches Lokaloszillatorsignal (Sr) mit einer vorzugsweise variablen Lokaloszillatorsignalfrequenz (Fr) bereitzustellen, die mit der Taktsignalfrequenz (Fclk) in einem ganzzahligen oder gebrochen-rationalen Verhältnis steht;
- einen dritten Signalgenerator (26; 226) (im Folgenden Triggersignalgenerator genannt), der auf Grundlage des Taktsignals ein periodisches Triggersignal (St) mit einer einstellbaren Triggersignalfrequenz (Ft) bereitstellt, die mit der Taktsignalfrequenz (Fclk) in einem ganzzahligen oder gebrochen-rationaten Verhältnis steht;
- Übertragungsmittel zum Übertragen des Treibersignals zu einem zu untersuchenden System (SUT);
- Empfangsmittel zum Empfangen wenigstens eines Ausgangssignals (u1, u2) von dem zu untersuchenden System (SUT);
- eine das Lokaloszillatorsignal und wenigstens ein Systemausgangssignal empfangende Mischeranordnung (14; 214) zum Herabmischen des Systemausgangssignals zu einer gegenüber dem Systemausgangssignal niedrigeren Frequenz;
- eine durch das Triggersignal getriggerte Analog-zu-Digital-Wandler-Anordnung (16; 116; 216), die ein für das Systemausgangssignal repräsentatives oder diesem entsprechendes Eingangssignal an durch das Triggersignal (St) bestimmten Zeitpunkten abtastet und den zeitlichen Verlauf des Eingangssignals repräsentierende Abtastwerte bereitstellt, wobei eine Komponente des Mischeranordnungsausgangssignals mit der niedrigeren Frequenz der Analog-zu-Digital-Wandler-Anordnung (16; 116; 216) als Eingangssignal zuführbar ist;
- eine digitale Prozessoreinrichtung (20; 120; 220), die auf der Grundlage der Abtastwerte wenigstens eine die Eigenschaft, ggf. die Reaktion des Systems auf das Treibersignal, charakterisierende Größe bestimmt.

5. Analysator nach Anspruch 2 oder 4, **dadurch gekennzeichnet, dass** wenigstens 16 verschiedene Triggersignalfrequenzen (Ft) durch die digitale Prozessoreinrichtung (20; 120; 220) einstellbar sind.

6. Analysator nach Anspruch 5, **dadurch gekennzeichnet, dass** wenigstens 16 verschiedene Frequenzverhältnisse (Ft / Fclk) zwischen der Triggersignalfrequenz (Ft) und der Taktsignalfrequenz (Fclk) durch die digitale Prozessoreinrichtung (20; 120; 220) einstellbar sind.

7. Analysator nach einem der Ansprüche 1 bis 6, **dadurch gekennzeichnet, dass** der Taktgenerator (222) dafür ausgelegt ist, auf Grundlage eines empfangenen Signals (Ss) mit einer festen oder variablen Frequenz (Fext) das periodische Taktsignal (Sclk) bereitzustellen, wobei die Taktfrequenz (Fclk) des Taktsignals (Sclk) mit der Frequenz (Fext) des empfangenen Signals (Ss) in einem ganzzahligen oder gebrochen-rationalen Verhältnis steht.

8. Analysator nach Anspruch 7, **dadurch gekennzeichnet, dass** der Analysator (210) dafür ausgelegt ist, ein System mit der extern vorgegebenen Frequenz (Fext) auf Grundlage einer gegenüber dem Analysator externen Frequenzquelle (224) zu analysieren, auf Grundlage des von dem Taktgenerator (222) empfangenen, von der externen Frequenzquelle stammenden Signals (Ss).

9. Analysator nach Anspruch 8, **dadurch gekennzeichnet, dass** der Analysator (210) dafür ausgelegt ist, in Kombination mit der gegenüber dem Analysator und dem zu untersuchtenden System gesonderten externen Frequenzquelle (224) verwendet zu werden.

10. Analysator nach Anspruch 8, **dadurch gekennzeichnet, dass** der Analysator (210) dafür ausgelegt ist, ein System zu analysieren, das die gegenüber dem Analysator externe Frequenzquelle (224) umfasst.

11. Analysator nach einem der vorhergehenden Ansprüche 4 bis 10, jedenfalls rückbezogen auf Anspruch 4, **dadurch gekennzeichnet, daß** der Analysator (10; 110; 210) zwischen einem ersten Betriebsmodus und einem zweiten Betriebsmodus umschaltbar ist, wobei im ersten Betriebsmodus das Systemausgangssignal (u1, u2), ggf. über eine Signalaufbereitungsanordnung (38a, 38b, 40a, 40b; 238a, 238b, 240a, 240b), der Analog-zu-Digital-Wandler-Anordnung (16; 116; 216) als dem Ausgangssignal entsprechendes Eingangssignal zugeführt wird und im zweiten Betriebsmodus das Systemausgangssignal, ggf. über eine/die Signalaufbereitungsanordnung (38a, 38b; 238a, 238b), der das Lokaloszillatorsignal (Sr) empfangenden Mischeranordnung (14; 214) zugeführt wird und die Komponente des Mischeranordnungsausgangssignals mit der niedrigeren Frequenz, ggf. über eine die Signalaufbereitungsanordnung (40a, 40b; 240a, 240b), der Analog-zu-Digital-Wandler-Anordnung (16; 116; 216) als für das Systemausgangssignal repräsentatives Eingangssignal zugeführt wird.

12. Analysator nach einem der vorhergehenden Ansprüche, **dadurch gekennzeichnet, daß** der Analysator (10; 110; 210) in wenigstens einem Betriebsmodus das Eingangssignal zur Analog-zu-Digital-Wandler-Anordnung, insbesondere das Systemausgangssignal, mit einer Abtastfrequenz kleiner als das Doppelte der Eingangssignalfrequenz abtastet, was auch als Unterabtastung bezeichnet wird.

13. Analysator nach einem der vorhergehenden Ansprüche, **dadurch gekennzeichnet, daß** die Analog-zu-Digital-Wandler-Anordnung eine Sample-Hold-Schaltungsanordnung umfaßt, um Eingangssignalfrequenzanteile mit Frequenzen über einer Grenzfrequenz einer Analog-zu-Digital-Wandler-Schaltungsanordnung der Analog-zu-Digital-Wandler-Anordnung erfassen zu können.

14. Analysator nach einem der vorhergehenden Ansprüche, **dadurch gekennzeichnet, daß** die erste Signalfrequenz (Fs) und die weitere Signalfrequenz (Fr; Ft) bzw. die Triggersignalfrequenz (Fclk), Treibersignalfrequenz (Fs) und Lokaloszillatorsignalfrequenz (Fr) in ganzzahligen oder gebrochen-rationalen Verhältnissen zueinander stehen, die durch die digitale Prozessoreinrichtung (20; 120; 220) einstellbar sind, insbesondere quasi-kontinuierlich einstellbar sind.

15. Analysator nach einem der vorhergehenden Ansprüche, **dadurch gekennzeichnet, daß** durch die digitale Prozessoreinrichtung (20; 120; 220) als erste Signalfrequenz (Fs) oder/und weitere Signalfrequenz (Fr; Ft) bzw. als Treibersignalfrequenz (Fs) oder/und als Lokaloszillatorfrequenz (Fr) oder/und als Triggersignalfrequenz (Ft) wenigstens 2⁴ verschiedene, vorzugsweise wenigstens 2⁸ verschiedene, noch stärker bevorzugt wenigstens 2¹⁶ verschiedene, höchstvorzugsweise wenigstens 2³² verschiedene Frequenzen einstellbar sind.

16. Analysator nach Anspruch 14 oder 15, **dadurch gekennzeichnet, daß** als ganzzahliges oder gebrochen-rationales Verhältnis jeder Wert V = N₁/N₂ durch die digitale Prozessoreinrichtung (20; 220) einstellbar ist, wobei N₁ und N₂ beliebige natürliche Zahlen größer Null sind und sich als digitale Integerzahlen mit wenigstens 8 Bit, vorzugsweise wenigstens 16 Bit, höchstvorzugsweise wenigstens 32 Bit, darstellen lassen.

17. Analysator nach einem der vorhergehenden Ansprüche, **dadurch gekennzeichnet, daß** das ganzzahlige oder gebrochen-rationale Verhältnis zwischen erster Signalfrequenz (Fs) und weiterer Signalfrequenz (Fr; Ft) bzw. zwischen
- Treibersignalfrequenz (Fs) und Taktsignalfrequenz (Fclk) oder/und
- Triggersignalfrequenz (Ft) und Taktsignalfrequenz (Fclk) oder/und
- Lokaloszillatorsignalfrequenz (Fr) und Taktsignalfrequenz (Fclk) durch die digitale Prozessoreinrichtung (20; 120; 220) einstellbar ist, insbesondere quasi-kontinuierlich einstellbar ist.

18. Analysator nach einem der vorhergehenden Ansprüche, **dadurch gekennzeichnet, daß** dem ersten Signalgenerator (24) und/oder dem weiteren Signalgenerator (26; 226) bzw. dem Triggersignalgenerator (26; 226) und/oder dem zweiten Signalgenerator (32; 232) ein Phasenwert eingebbar ist, um den eine generatorinterne Phase des jeweiligen Ausgangssignals (Treibersignal (Ss), Triggersignal (St) bzw. Lokaloszillatorsignal (Sr)) für jeden Takt des Taktsignals (Sclk) vergrößert wird.

19. Analysator nach Anspruch 18, **dadurch gekennzeichnet, daß** der Phasenwert in Form eines Werts eingebbar ist, der die resultierende Frequenz (Fs, Fr bzw. Ft) des Generatorausgangssignals als Bruchteil der Frequenz (Fclk) des Taktsignals definiert.

20. Analysator nach Anspruch 18 oder 19, **dadurch gekennzeichnet, daß** die als digitale ganze Zahl repräsentierte generatorinterne Phase die Adresse eines zugeordneten, digital repräsentierten Amplitudenwerts des Generatorausgangssignals in einer generatorinternen Tabelle (62) angibt, der einem das Generatorausgangssignal abgebenden Digital-zu-Analog-Wandler (64) zuführbar ist.

21. Analysator nach einem der Ansprüche 1 bis 17, **dadurch gekennzeichnet, daß** der erste Signalgenerator (24) und/oder der weitere Signalgenerator (32; 232; 26; 226) bzw. Triggersignalgenerator (26; 226) und/oder der zweite Signalgenerator (32; 232) eine PLL- , Schaltung umfaßt, die das Taktsignal (Sclk) zu einer höheren oder tieferen Frequenz (Fs) bzw. (Ft) bzw. (Fr) frequenztransformiert.

22. Analysator nach Anspruch 21, **dadurch gekennzeichnet, daß** die PLL-Schaltung ein Frequenzmultiplizierglied oder/und ein Frequenzdividierglied mit durch die digitale Prozessoreinrichtung einstellbarem Frequenzmultiplikationsfaktor bzw. Frequenzdivisionsfaktor umfaßt.

23. Analysator nach einem der Ansprüche 2 bis 22, jedenfalls rückbezogen auf Anspruch 2 oder 4, **dadurch gekennzeichnet, daß** die digitale Prozessoreinrichtung (20; 220) das Triggersignal (St) empfängt und an von durch das Triggersignal bestimmten Zeitpunkten von der Analog-zudigital-Wandler-Anordnung (16) bereitgestellte Abtastwerte aufnimmt.

24. Analysator nach einem der vorhergehenden Ansprüche, **dadurch gekennzeichnet, daß** zur Erweiterung des Frequenzbereichs einer Generatorschaltung des Taktgenerators (22; 222), und/oder des ersten Signalgenerators (24) und/oder des weiteren Signalgenerator (32; 232; 26; 226) bzw. des Triggersignalgenerators (26; 226) und/oder des zweiten Signalgenerators (32; 232) eine jeweilige Frequenztransformationsschaltung (70, 72 bzw. 74) vorgesehen ist, die der Generatorschaltung nachgeschaltet oder für bestimmte Betriebszustände nachschaltbar ist.

25. Analysator nach Anspruch 24, **dadurch gekennzeichnet, daß** die Frequenztransformationsschaltung ein Frequenz-Dividierglied (74) oder/und ein Frequenz-Potenzierglied (70, 72) oder/und eine PLL-Schaltung oder/und ein Mischerglied mit zugeordnetem Lokaloszillator umfaßt.

26. Analysator nach einem der vorhergehenden Ansprüche, **dadurch gekennzeichnet, daß** die Bestimmung der charakterisierenden Größe die Durchführung einer digitalen Fouriertransformation auf Grundlage der Abtastwerte oder auf Grundlage von aus diesen durch weitere Verarbeitung gewonnenen Verarbeitungswerten umfaßt.

27. Analysator nach Anspruch 26, **dadurch gekennzeichnet, daß** die wenigstens eine charakterisierende Größe die relative Amplitude/relativen Amplituden (A 1/A2) und die relative Phase/ relativen Phasen (W1 - W2) zwischen Fourierkomponenten von wenigstens zwei verschiedenen Ausgangssignalen (u1, u2) vom zu untersuchenden System (SUT) umfaßt, oder/und wenigstens eine Amplitude (A1, A2) oder/und wenigstens eine auf das Treibersignal (Ss) bezogene relative Amplitude oder/und wenigstens eine auf das Treibersignal (Ss) bezogene relative Phase (W1, W2) wenigstens einer Fourierkomponente von wenigstens einem Ausgangssignal (u1, u2) vom zu untersuchenden System (SUT) umfaßt.

28. Analysator nach einem der vorhergehenden Ansprüche, **dadurch gekennzeichnet, daß** der Taktgenerator ein interner Taktgenerator (122) der digitalen Prozessoreinrichtung (120) ist oder auf Grundlage eines internen Taktgenerators sowie anderer Hardwarekomponenten oder/und Software-Funktionalitäten der digitalen Prozessoreinrichtung realisiert ist, wobei der erste Signalgenerator oder/und der zweite Signalgenerator oder/und der Triggersignalgenerator auf Grundlage von Hardwarekomponenten der digitalen Prozessoreinrichtung (120) oder/und dieser zugeordneter externer Hardwarekomponenten durch Software-Funktionalitäten der digitalen Prozessoreinrichtung (120) realisiert sind.

29. Analysator nach einem der Ansprüche 2 bis 28, **dadurch gekennzeichnet, daß** der Taktgenerator (222) eine Frequenzumsetzungsanordnung, vorzugsweise eine Frequenzvervielfachungsanordnung (293, 294) umfaßt, die die Frequenz (Fext) des empfangenen Signals (Ss) zur Frequenz (Fxlk) des Taktsignals (Sclk) umsetzt.

30. Analysator nach Anspruch 29, **dadurch gekennzeichnet, daß** die Frequenzumsetzungsanordnung (293, 294) ein Frequenzmultiplizierglied oder eine Frequenzvervielfachungsschleife (293) umfaßt, die die Frequenz (Fext) des empfangenen Signals (Ss) oder eine hieraus abgeleitete interne Frequenz um einen ganzzahligen Faktor (n) vervielfacht, oder/und daß die Frequenzumsetzungsanordnung (293, 294) ein Frequenzteiterglied (294) oder eine Frequenzdivisionsschleife umfaßt, die die Frequenz (Fext) des empfangenen Signals (Ss) oder eine hieraus abgeleitete interne Frequenz (Fext^{*}n) um einen ganzzahligen Teilerfaktor (m) erniedrigt.

31. Verfahren, insbesondere Frequenzganganalyseverfahren, zum Messen wenigstens einer sich auf eine Frequenz beziehenden Eigenschaft eines zu untersuchenden Systems, ggf. der Reaktion des zu untersuchenden Systems auf wenigstens ein periodisches Treibersignal (Ss) fester oder variabler Frequenz, das Verfahren umfassend:
a1) Bereitstellen eines periodischen Taktsignals (Sclk) mit einer Taktfrequenz (Fclk);
a2) Bereitstellen eines periodischen Treibersignals (Ss) mit einer variablen Treibersignalfrequenz (Fs), die mit der Taktsignalfrequenz (Fclk) in einem ganzzahligen oder gebrochen-rationalen Verhältnis steht;
a3) Übertragen des Treibersignals zu einem zu untersuchenden System (SUT);
oder umfassend:
b1) Bereitstellen eines Signals mit einer festen oder variablen Frequenz (Fext) in Zuordnung zu einem zu untersuchenden System;
b2) Empfangen des Signals mit der festen oder variablen Frequenz (Fext) und Bereitstellen, auf Grundlage des empfangenen Signals mit der festen oder variablen Frequenz (Fext), eines periodischen Taktsignals (Sclk) mit einer Taktfrequenz (Fclk), die mit der Frequenz (Fext) des empfangenen Signals in einem ganzzahligen oder gebrochen-rationalen Verhältnis steht;
das Verfahren ferner umfassend:
c1) Bereitstellen eines periodischen, als Lokaloszillatorsignal oder Triggersignal verwendbaren weiteren Signals (Sr; St) mit einer vorzugsweise variablen weiteren Signalfrequenz (Fr; Ft), die mit der Taktsignalfrequenz (Fclk) in einem ganzzahligen oder gebrochen-rationalen Verhältnis steht;
c2) Empfangen wenigstens eines Ausgangssignals (u1, u2) von dem zu untersuchenden System (SUT);
c3) auf Grundlage des weiteren Signals (Sr; St) Erzeugen von digitalen Abtastwerten durch Abtasten eines für das Systemausgangssignal repräsentativen oder diesem entsprechenden Signals, derart, dass die digitalen Abtastwerte den zeitlichen Verlauf dieses Signals repräsentieren;
c4) Bestimmen wenigstens einer die Eigenschaft, ggf. die Reaktion des Systems auf das Treibersignal, charakterisierenden Größe auf Grundlage der Abtastwerte.

32. Verfahren nach Anspruch 31, **dadurch gekennzeichnet, dass** das weitere Signal als Triggersignal (St) dient und zur Erzeugung der digitalen Abtastwerte das für das Systemausgangssignal repräsentative oder diesem entsprechende Signal an durch das Triggersignal (St) bestimmten Zeitpunkten abgetastet wird.

33. Verfahren nach Anspruch 31, **dadurch gekennzeichnet, dass** das weitere Signal als Lokaloszillatorsignal (Sr) dient und auf Grundlage des Lokaloszillatorsignals (Sr) das Systemausgangsignal zu einer gegenüber dem Systemausgangssignal niedrigeren Frequenz herabgemischt wird, und dass eine Komponente eines beim Herabmischen entstehenden Signals, die die niedrigere Frequenz aufweist, abgetastet wird, um die digitalen Abtastwerte bereitzustellen.

## Claims

1. Analyser, optionally a frequency response analyser, for measuring at least one property relating to a frequency of a system to be analysed, optionally the reaction of the system to be analysed to at least one periodic driver signal (Ss) of fixed or variable frequency (Fext), comprising:
- a clock-pulse generator (22; 122; 222) which is designed to provide a periodic clock-pulse signal (Sclk) with a clock-pulse frequency (Fclk);
- a first signal generator (24) which is designed to provide, on the basis of the clock-pulse signal, a periodic first signal (Ss) which can be used as the driver signal with a variable first signal frequency (Fs), which is in an integral or fractional-rational ratio to the clock-pulse signal frequency (Fclk);
- a further signal generator (32; 232; 26; 226) which is designed to provide, on the basis of the clock-pulse signal, a periodic further signal (Sr; St) which can be used as a local oscillator signal or trigger signal with a preferably variable further signal frequency (Fr; Ft), which is in an integral or fractional-rational ratio to the clock-pulse signal frequency (Fclk);
- transmission means for transmitting the first signal to a system to be analysed (SUT);
- receiving means for receiving at least one output signal (u1, u2) from the system to be analysed (SUT);
- a mixer or sampling arrangement (14, 16; 16; 116; 214, 216; 216) receiving the further signal and at least one system output signal;
- an analogue-digital converter arrangement (16; 116; 216) associated with the mixer or sampling arrangement (14, 16; 16; 116; 214, 216; 216) which is designed to provide, on the basis of an input signal which is representative of the system output signal or corresponds thereto, digital sampling values representing the time course of the input signal, wherein at least one component of the output signal of the mixer or sampling arrangement (14, 16; 16; 116; 214, 216; 216) can be supplied as an input signal to the analogue-digital converter arrangement (16; 116; 216);
- a digital processor arrangement (20, 120; 220) which is designed to determine, on the basis of the sampling values, at least one variable **characterising** the property, optionally the reaction of the system to the driver signal.

2. Analyser according to claim 1, **characterised in that** the further signal generator serves as a trigger signal generator (26; 226) which is designed to provide, on the basis of the clock-pulse signal, a periodic trigger signal (St) with an adjustable trigger signal frequency (Ft) which is in an integral or fractional-rational ratio to the clock-pulse signal frequency (Fclk); wherein the sampling arrangement in conjunction with the analogue-digital converter arrangement (16; 116; 216) is triggerable by the trigger signal (St) to sample the input signal at points in time determined by the trigger signal and to provide corresponding digital sampling values.

3. Analyser according to claim 1, **characterised in that** the further signal generator serves as a local oscillator signal generator (32; 232) which is designed to provide, on the basis of the clock-pulse signal, a periodic local oscillator signal (Sr), with a preferably variable local oscillator signal frequency (Fr), which is in an integral or fractional-rational ratio to the clock-pulse signal frequency (Fclk), the mixer arrangement (14; 214) receiving the local oscillator signal serving to mix the system output signal down to a lower frequency compared to the system output signal, wherein one component of the mixer arrangement output signal with the lower frequency can be supplied to the analogue-digital converter arrangement (16; 116; 216) as an input signal representative of the system output signal.

4. Analyser, optionally frequency response analyser, for measuring at least one property relating to a frequency of a system to be analysed, optionally the reaction of the system to be analysed to at least one periodic driver signal (Ss) of fixed or variable frequency (Fext), comprising:
- a clock-pulse generator (22; 122, 222) which is designed to provide a periodic clock-pulse signal (Sclk) with a clock-pulse frequency (Fclk);
- a first signal generator (24) which is designed to provide, on the basis of the clock-pulse signal, a periodic first signal (Ss) which can be used as the driver signal with a variable first signal frequency (Fs), which is an integral or fractional-rational ratio to the clock-pulse signal frequency (Fclk);
- a second signal generator (32, 232), which is designed to provide, on the basis of the clock-pulse signal, a periodic local oscillator signal (Sr), with a preferably variable local oscillator signal frequency (Fr) which is in an integral or fractional-rational ratio to the clock-pulse signal frequency (Fclk);
- a third signal generator (26; 226) (hereinafter called a trigger signal generator), which provides, on the basis of the clock-pulse signal, a periodic trigger signal (St) with an adjustable trigger signal frequency (Ft) which is in an integral or fractional-rational ratio to the clock-pulse signal frequency (Fclk);
- transmission means for transmitting the driver signal to a system to be analysed (SUT);
- receiving means for receiving at least one output signal (u1, u2) from the system to be analysed (SUT);
- a mixture arrangement (14; 214) receiving the local oscillator signal and at least one system output signal for mixing the system output signal down to a lower frequency compared to the system output signal;
- an analogue-digital converter arrangement (16; 116; 216) triggered by the trigger signal and sampling an input signal which is representative of the system output signal or corresponds thereto at points in time determined by the trigger signal (St) and providing the time course of the sampling values representing the input signal, wherein a component of the mixer arrangement output signal with the lower frequency can be supplied as an input signal to the analogue-digital converter arrangement (16; 116; 216);
- a digital processor device (20; 120; 220) which determines, on the basis of the sampling values, at least one variable **characterising** the property, optionally the reaction of the system to the driver signal.

5. Analyser according to claim 2 or 4, **characterised in that** at least 16 different trigger signal frequencies (Ft) can be adjusted by the digital processor device (20; 120; 220).

6. Analyser according to claim 5, **characterised in that** at least 16 different frequency ratios (Ft/Fclk) can be adjusted between the trigger signal frequency (Ft) and the clock-pulse signal frequency (Fclk) by the digital processor device (20, 120; 220).

7. Analyser according to any one of claims 1 to 6, **characterised in that** the clock-pulse generator (222) is designed to provide, on the basis of a received signal (Ss) with a fixed or variable frequency (Fext), the periodic clock-pulse signal (Sclk), the clock-pulse frequency (Fclk) of the clock-pulse signal (Sclk) being in an integral or fractional-rational ratio to the frequency (Fext) of the received signal (Ss) .

8. Analyser according to claim 7, **characterised in that** the analyser (210) is designed to analyse a system with the externally predetermined frequency (Fext) on the basis of a frequency source (224) which is external relative to the analyser, on the basis of the signal (Ss) received by the clock-pulse generator (222) and coming from the external frequency source.

9. Analyser according to claim 8, **characterised in that** the analyser (210) is designed to be used in combination with the frequency source (224) which is separate and external relative to the analyser and the system to be analysed.

10. Analyser according to claim 8, **characterised in that** the analyser (210) is designed to analyse a system which comprises the frequency source (224) which is external relative to the analyser.

11. Analyser according to any one of the preceding claims 4 to 10, in any case referring back to claim 4, **characterised in that** the analyser (10; 110; 210) can be switched between a first operating mode and a second operating mode, the system output signal (u1, u2), being supplied in the first operating mode, optionally via a signal conditioning arrangement (38a, 38b, 40a, 40b; 238a, 238b, 240a, 240b), to the analogue-digital converter arrangement (16; 116; 216) as the input signal corresponding to the output signal and the system output signal is supplied in the second operating mode, optionally via a/the signal conditioning arrangement (38a, 38b; 238a, 238b) to the mixer arrangement (14; 214) receiving the local oscillator signal (Sr) and the component of the mixer arrangement output signal with the lower frequency is supplied optionally via a/the signal conditioning arrangement (40a, 40b; 240a, 240b) to the analogue-digital converter arrangement (16; 116; 216) as the input signal which is representative of the system output signal.

12. Analyser according to any one of the preceding claims, **characterised in that** the analyser (10; 110; 210) in at least one operating mode samples the input signal to the analogue-digital converter arrangement, in particular the system output signal, with a sampling frequency which is smaller than twice the input signal frequency, and this is also known as undersampling.

13. Analyser according to any one of the preceding claims, **characterised in that** the analogue-digital converter arrangement comprises a sample-and-hold circuit arrangement in order to be able to detect input signal frequency parts with frequencies above a limit frequency of an analogue-digital converter circuit arrangement of the analogue-digital converter arrangement.

14. Analyser according to any one of the preceding claims, **characterised in that** the first signal frequency (Fs) and the further signal frequency (Fr; Ft) or the trigger signal frequency (Fclk), driver signal frequency (Fs) and local oscillator signal frequency (Fr) are in integral or fractional-rational ratios to one another which can be adjusted by the digital processor device (20; 120; 220), in particular virtually continuously.

15. Analyser according to any one of the preceding claims, **characterised in that** at least 2⁴ different, preferably at least 2⁸ different, still more preferably at least 2¹⁶ different, most preferably at least 2³² different frequencies can be adjusted by the digital processor device (20; 120; 220) as the first signal frequency (Fs) or/and further signal frequency (Fr; Ft) or as the driver signal frequency (Fs) or/and as the local oscillator frequency (Fr) or/and as the trigger signal frequency (Ft).

16. Analyser according to claim 14 or 15, **characterised in that** each value V = N₁/N₂ can be adjusted by the digital processor device (20; 220) as an integral or fractional-rational ratio, wherein N₁ and N₂ are any natural numbers greater than zero and can be represented as digital integral numbers with at least 8 bits, preferably at least 16 bits, most preferably at least 32 bits.

17. Analyser according to any one of the preceding claims, **characterised in that** the integral or fractional-rational ratio between the first signal frequency (Fs) and the further signal frequency (Fr; Ft) or between
- the driver signal frequency (Fs) and clock-pulse signal frequency (Fclk) or/and
- the trigger signal frequency (Ft) and clock-pulse signal frequency (Fclk) or/and
- the local oscillator signal frequency (Fr) and clock-pulse signal frequency (Fclk) can be adjusted by the digital processor device (20; 120; 220), in particular virtually continuously.

18. Analyser according to any one of the preceding claims, **characterised in that** a phase value can be input to the first signal generator (24) and/or the further signal generator (26, 226) or the trigger signal generator (26; 226) and/or the second signal generator (32; 232) by which a phase which is internal to the generator of the respective output signal (driver signal (Ss), trigger signal (St) or local oscillator signal (Sr)) is increased for each clock-pulse of the clock-pulse signal (Sclk).

19. Analyser according to claim 18, **characterised in that** the phase value can be input in the form of a value which defines the resulting frequency (Fs, Fr or Ft) of the generator output signal as a fraction of the frequency (Folk) or the clock-pulse signal.

20. Analyser according to claim 18 or 19, **characterised in that** the phase which is internal to the generator represented as a digital integral number provides the address of an associated, digitally represented amplitude value of the generator output signal in a table (62) which is internal to the generator, which amplitude value can be supplied to a digital/analogue converter (64) emitting the generator output signal.

21. Analyser according to any one of claims 1 to 17, **characterised in that** the first signal generator (24) and/or the further signal generator (32; 232; 26; 226) or the trigger signal generator (26; 226) and/or the second signal generator (32; 232) comprise a PLL circuit, which frequency-transforms the clock-pulse signal (Sclk) to a higher or lower frequency (Fs) or (Ft).

22. Analyser according to claim 21, **characterised in that** the PLL circuit comprises a frequency multiplying element or/and a frequency dividing element with a frequency multiplication factor or frequency division factor which can be adjusted by the digital processor device.

23. Analyser according to any one of claims 2 to 22, in any case referring back to claim 2 or 4, **characterised in that** the digital processor device (20; 220) receives the trigger signal (St) and receives sampling values provided by the analogue-digital converter arrangement (116) at points in time determined by the trigger signal.

24. Analyser according to any one of the preceding claims, **characterised in that** to extend the frequency range of a generator circuit of the clock-pulse generator (22; 222), and/or the first signal generator (24), and/or the further signal generator (32; 232; 26; 226) or of the trigger signal generator (26; 226) and/or the second signal generator (32; 232) , a respective frequency transformation circuit (70, 72 or 74) is provided which is connected downstream from the generator circuit or can be connected downstream for certain operating states.

25. Analyser according to claim 24, **characterised in that** the frequency transformation circuit comprises a frequency dividing element (74) or/and a frequency-exponentiating element (70, 72) or/and a PLL circuit or/and a mixer element with associated local oscillator.

26. Analyser according to any one of the preceding claims, **characterised in that** the determination of the characterising variable comprises carrying out a digital Fourier transformation on the basis of the sampling values or on the basis of processing values obtained therefrom by further processing.

27. Analyser according to claim 26, **characterised in that** the at least one characterising variable comprises the relative amplitude/relative amplitudes (A1/A2) and the relative phase/relative phases (W1 - W2) between the Fourier components of at least two different output signals (u1, u2) of the system to be analysed (SUT), or/and at least one amplitude (A1, A2) or/and at least one relative amplitude based on the driver signal (Ss) or/and at least one relative phase (W1, W2) based on the driver signal (Ss) of at least one Fourier component of at least one output signal (u1, u2) of the system to be analysed (SUT).

28. Analyser according to any one of the preceding claims, **characterised in that** the clock-pulse generator is an internal clock-pulse generator (122) of the digital processor device (120) or is produced on the basis of an internal clock-pulse generator and other hardware components or/and software functionalities of the digital processor device, the first signal generator or/and the second signal generator or/and the trigger signal generator being produced by software functionalities of the digital processor device (120) on the basis of hardware components of the digital processor device (120) or/and external hardware components associated therewith.

29. Analyser according to any one of claims 2 to 28, **characterised in that** the clock-pulse generator (222) comprises a frequency conversion arrangement, preferably a frequency multiplying arrangement (293, 294) which converts the frequency (Fext) of the received signal (Ss) to the frequency (Fxlk) of the clock-pulse signal (Sclk).

30. Analyser according to claim 29, **characterised in that** the frequency conversion arrangement (293, 294) comprises a frequency multiplying element or frequency multiplying loop (293), which multiplies the frequency (Fext) of the received signal (Ss) or an internal frequency derived therefrom by an integral factor (n), or/and **in that** the frequency conversion arrangement (293, 294) comprises a frequency divider element (294) or a frequency division loop which reduces the frequency (Fext) of the received signal (Ss) or an internal frequency (Fext^{*}n) derived therefrom by an integral divisor factor (m).

31. Method, in particular frequency response analysis method, for measuring at least one property relating to a frequency, of a system to be analysed, optionally the reaction of the system to be analysed to at least one periodic driver signal (Ss) of fixed or variable frequency, the method comprising:
a1) providing a periodic clock-pulse signal (Sclk) with a clock-pulse frequency (Fclk);
a2) providing a periodic driver signal (Ss) with a variable driver signal frequency (Fs) which is in an integral or fractional-rational ratio to the clock-pulse signal frequency (Fclk);
a3) transmitting the driver signal to a system to be analysed (SUT);
or comprising:
b1) providing a signal with a fixed or variable frequency (Fext) in association with a system to be analysed;
b2) receiving the signal with a fixed or variable frequency (Fext) and providing, on the basis of the signal received with the fixed or variable frequency (Fext), a periodic clock-pulse signal (Sclk) with a clock-pulse frequency (Fclk) which is in an integral or fractional-rational ratio to the frequency (Fext) of the received signal ;
the method also comprising:
c1) providing a periodic further signal (Sr; St) which can be used as a local oscillator signal or trigger signal with a preferably variable further signal frequency (Fr; Ft) which is in an integral or fractional-rational ratio to the clock-pulse signal frequency (Fclk);
c2) receiving at least one output signal (u1, u2) from the system to be analysed (SUT);
c3) generating digital sampling values on the basis of the further signal (Sr; St) by sampling a signal which is representative of the system output signal or corresponds thereto, in such a way that the digital sampling values represent the time course of this signal;
c4) determining at least one variable **characterising** the property, optionally the reaction of the system to the driver signal, on the basis of the sampling values.

32. Method according to claim 31, **characterised in that** the further signal serves as a trigger signal (St) and the signal representative of the system output signal or corresponding thereto is sampled at points in time determined by the trigger signal (St) to generate the digital sampling values.

33. Method according to claim 31, **characterised in that** the further signal serves as a local oscillator signal (Sr) and on the basis of the local oscillator signal (Sr), the system output signal is mixed down to a lower frequency compared to the system output signal, and **in that** a component of a signal occurring during mixing down and having the lower frequency is sampled to provide the digital sampling values.

## Revendications

1. Analyseur, le cas échéant analyseur de fréquence de réponse, pour mesurer au moins une caractéristique spécifique relative à une fréquence d'un système à vérifier, le cas échéant la réaction du système à vérifier à au moins un signal de commande (Ss) périodique de fréquence fixe ou variable (Fext), comprenant :
- d'un générateur d'horloge (22 ; 122 ; 222), qui est conçu pour délivrer un signal d'horloge périodique (Sclk) avec une fréquence d'horloge (Fclk) ;
- un premier générateur de signal (24), qui est conçu pour délivrer, sur la base du signal d'horloge, un premier signal (Ss) périodique, pouvant être utilisé en tant que signal de commande, avec une première fréquence de signal (Fs) variable, qui a une relation rationnelle fractionnaire ou en nombre entier avec la fréquence du signal d'horloge (Fclk) ;
- un autre générateur de signal (32 ; 232 ; 26 ; 226), qui est conçu pour délivrer, sur la base du signal d'horloge, un autre signal (Sr ; St) périodique, pouvant être utilisé en tant que signal d'oscillateur local ou signal de déclenchement, avec une autre fréquence de signal (Fr ; Ft) de préférence variable, qui a une relation rationnelle fractionnaire ou en nombre entier avec la fréquence du signal d'horloge (Fclk) ;
- des moyens de transmission pour transmettre le premier signal à un système à vérifier (SUT) ;
- des moyens de réception pour recevoir au moins un signal de sortie (u1, u2) provenant du système (SUT) à vérifier ;
- un dispositif de mélange ou d'échantillonnage (14, 16 ; 16 ; 116, 214, 216 ; 216) recevant l'autre signal et au moins un signal de sortie du système ;
- un dispositif de conversion analogique-numérique (16 ; 116 ; 216) associé au dispositif de mélange ou d'échantillonnage (14, 16 ; 16 ; 116, 214, 216 ; 216), qui est conçu pour délivrer, sur la base d'un signal d'entrée représentatif du signal de sortie du système ou correspondant à celui-ci, des valeurs d'échantillonnage numériques représentant la répartition dans le temps du signal d'entrée, moyennant quoi au moins une composante du signal de sortie du dispositif de mélange ou d'échantillonnage (14, 16 ; 16 ; 116, 214, 216 ; 216) peut être appliquée, en tant que signal d'entrée, au dispositif de conversion analogique-numérique (16 ; 116 ; 216) ;
- une unité de processeur numérique (20 ; 120 ; 220), qui est conçue pour déterminer, sur la base des valeurs d'échantillonnage, au moins une grandeur caractérisant la caractéristique spécifique, le cas échéant la réaction du système au signal de commande.

2. Analyseur selon la revendication 1, **caractérisé en ce que** l'autre générateur de signal fait office de générateur de signal de déclenchement (26 ; 226), qui est conçu pour délivrer, sur la base du signal d'horloge, un signal de déclenchement (St) périodique avec une fréquence de signal de déclenchement (Ft) réglable, qui a une relation rationnelle fractionnaire ou en nombre entier avec la fréquence du signal d'horloge (Fclk) ;
le dispositif échantillonneur pouvant être déclenché en liaison avec le dispositif de conversion analogique-numérique (16 ; 116 ; 226) par le signal de déclenchement (St), pour échantillonner le signal d'entrée à des moments définis par le signal de déclenchement et pour délivrer des valeurs d'échantillonnage numériques correspondantes.

3. Analyseur selon la revendication 1, **caractérisé en ce que** l'autre générateur de signal fait office de générateur de signal d'oscillateur local (32 ; 232), qui est conçu pour délivrer, sur la base du signal d'horloge, un signal d'oscillateur local (Sr) périodique avec une fréquence d'oscillateur local (Fr) de préférence variable, qui a une relation rationnelle fractionnaire ou en nombre entier avec la fréquence du signal d'horloge (Fclk), le dispositif mélangeur (14 ; 214), recevant le signal d'oscillateur local, servant à mélanger le signal de sortie du système en le ramenant à une fréquence plus basse par rapport au signal de sortie du système, une composante du signal de sortie du dispositif mélangeur avec la fréquence plus basse pouvant être appliquée, en tant que signal d'entrée représentatif du signal de sortie du système, au dispositif de conversion analogique-numérique (16 ; 116 ; 216).

4. Analyseur, le cas échéant analyseur de fréquence de réponse, pour mesurer au moins une caractéristique spécifique relative à une fréquence d'un système à vérifier, le cas échéant la réaction du système à vérifier à au moins un signal de commande (Ss) périodique de fréquence fixe ou variable (Fext), comprenant :
- d'un générateur d'horloge (22 ; 122 ; 222), qui est conçu pour délivrer un signal d'horloge (Sclk) périodique avec une fréquence d'horloge (Fclk) ;
- un premier générateur de signal (24), qui est conçu pour délivrer, sur la base du signal d'horloge, un premier signal (Ss) périodique, pouvant être utilisé en tant que signal de commande, avec une première fréquence de signal (Fs) variable, qui a une relation rationnelle fractionnaire ou en nombre entier avec la fréquence du signal d'horloge (Fclk) ;
- un deuxième générateur de signal (32 ; 232), qui est conçu pour délivrer, sur la base du signal d'horloge, un signal d'oscillateur local (Sr) périodique avec une fréquence de signal d'oscillateur variable (Fr) de préférence variable, qui a une relation rationnelle fractionnaire ou en nombre entier avec la fréquence du signal d'horloge (Fclk) ;
- un troisième générateur de signal (26 ; 226) (désigné ci-après comme générateur de signal de déclenchement) qui, sur la base du signal d'horloge, délivre un signal de déclenchement (St) périodique avec une fréquence de signal de déclenchement (Ft) réglable, qui a une relation rationnelle fractionnaire ou en nombre entier avec la fréquence du signal d'horloge (Fclk) ;
- des moyens de transmission pour transmettre le signal de commande à un système à vérifier (SUT) ;
- des moyens de réception pour recevoir au moins un signal de sortie (u1, u2) provenant du système (SUT) à vérifier ;
- un dispositif mélangeur (14 ; 214) recevant le signal d'oscillateur local et au moins un signal de sortie du système pour mélanger le signal de sortie du système en le ramenant à une fréquence plus basse par rapport au signal de sortie du système ;
- un dispositif de conversion analogique-numérique (16 ; 116 ; 216), déclenché par le signal de déclenchement, qui échantillonne un signal d'entrée représentatif du signal de sortie du système ou correspondant à celui-ci à des moments définis par le signal de déclenchement (St) et délivre des valeurs d'échantillonnage numériques représentant la répartition dans le temps du signal d'entrée, une composante du signal de sortie du dispositif mélangeur avec la fréquence plus basse pouvant être appliquée, en tant que signal d'entrée, au dispositif de conversion analogique-numérique (16 ; 116 ; 216) ;
- une unité de processeur numérique (20 ; 120 ; 220), qui détermine, sur la base des valeurs d'échantillonnage, au moins une grandeur caractérisant la caractéristique spécifique, le cas échéant la réaction du système au signal de commande.

5. Analyseur selon la revendication 2 ou 4, **caractérisé en ce qu'**au moins 16 différentes fréquences du signal de déclenchement (Ft) peuvent être réglées par l'unité de processeur numérique (20 ; 120 ; 220).

6. Analyseur selon la revendication 5, **caractérisé en ce qu'**au moins 16 relations de fréquence différentes (Ft/Fclk) entre la fréquence du signal de déclenchement (Ft) et la fréquence du signal d'horloge (Fclk) peuvent être réglées par l'unité de processeur numérique (20 ; 120 ; 220).

7. Analyseur selon une quelconque des revendications 1 à 6, **caractérisé en ce que** le générateur d'horloge (222) est conçu pour délivrer, sur la base d'un signal (Ss) reçu avec une fréquence (Fext) fixe ou variable, le signal d'horloge (Sclk) périodique, la fréquence d'horloge (Fclk) du signal d'horloge (Sclk) ayant une relation rationnelle fractionnaire ou en nombre entier avec la fréquence (Fext) du signal (Ss) reçu.

8. Analyseur selon la revendication 7, **caractérisé en ce que** l'analyseur (210) est conçu pour analyser, sur la base d'une source de fréquence (224) externe par rapport à l'analyseur, un système avec la fréquence externe (Fext) prédéterminée, sur la base du signal (Ss) provenant de la source de fréquence externe, reçu du générateur d'horloge (222).

9. Analyseur selon la revendication 8, **caractérisé en ce que** l'analyseur (210) est conçu pour être utilisé en combinaison avec la source de fréquence externe (224) distincte de l'analyseur et du système à vérifier.

10. Analyseur selon la revendication 8, **caractérisé en ce que** l'analyseur (210) est conçu pour analyser un système, qui comprend la source de fréquence (224) externe eu égard à l'analyseur.

11. Analyseur selon l'une quelconque des revendications précédentes 4 à 10 et, en tout cas, en référence à la revendication 4, **caractérisé en ce que** l'analyseur (10 ; 110 ; 210) peut être commuté d'un premier mode opératoire à un second mode opératoire, moyennant quoi, dans le premier mode opératoire, le signal de sortie du système (u1, u2) est appliqué, en tant que signal d'entrée correspondant au signal de sortie, au dispositif de conversion analogique-numérique (16 ; 116 ; 216), le cas échéant via un dispositif de mise en forme du signal (38a, 38b, 40a, 40b ; 238a, 238b, 240a, 240b) et, dans le second mode opératoire, le signal de sortie du système est appliqué au dispositif mélangeur (14 ; 214) recevant le signal d'oscillateur local (Sr), le cas échéant via un/le dispositif de mise en forme du signal (38a, 38b ; 238a, 238b), et la composante du signal de sortie du dispositif mélangeur avec la fréquence plus basse est appliquée, en tant que signal d'entrée représentatif du signal de sortie du système, au dispositif de conversion analogique-numérique (16 ; 116 ; 216), le cas échéant via un/le dispositif de mise en forme du signal (40a, 40b ; 240a, 240b).

12. Analyseur selon l'une quelconque des revendications précédentes, **caractérisé en ce que** l'analyseur (10 ; 110 ; 210) dans au moins un mode opératoire, échantillonne le signal d'entrée appliqué au dispositif de conversion analogique-numérique, en particulier le signal de sortie du système, avec une fréquence d'échantillonnage inférieure au double de la fréquence du signal d'entrée, ce que l'on désigne également par sous-échantillonnage.

13. Analyseur selon l'une quelconque des revendications précédentes, **caractérisé en ce que** le dispositif de conversion analogique-numérique comprend un dispositif de circuit échantillonneur bloqueur (PLL), afin de pouvoir enregistrer des parties de fréquence de signal d'entrée avec des fréquences au-delà d'une fréquence seuil d'un dispositif de circuit de conversion analogique-numérique du dispositif de conversion analogique-numérique.

14. Analyseur selon l'une quelconque des revendications précédentes, **caractérisé en ce que** la première fréquence de signal (Fs) et l'autre fréquence de signal (Fr ; Ft), ou la fréquence du signal de déclenchement (Fclk), la fréquence du signal de commande (Fs) et la fréquence du signal d'oscillateur local (Fr) ont entre elles des relations rationnelles fractionnaires ou en nombre entier, qui peuvent être réglées par l'unité de processeur numérique (20 ; 120 ; 220), en particulier de façon quasi-continue.

15. Analyseur selon l'une quelconque des revendications précédentes, **caractérisé en ce qu'**au moins 2⁴ fréquences différentes, de préférence au moins 2⁸ fréquences différentes, de manière davantage préférée au moins 2¹⁶ fréquences différentes et, de manière préférée entre toutes, au moins 2³² fréquences différentes peuvent être réglées en tant que première fréquence de signal (Fs) ou/et en tant qu'autre fréquence de signal (Fr ; Ft) ou en tant que fréquence du signal de commande (Fs) ou/et en tant que fréquence d'oscillateur local (Fr) ou/et en tant que fréquence du signal de déclenchement (Ft), par l'unité de processeur numérique (20 ; 120 ; 220).

16. Analyseur selon la revendication 14 ou 15, **caractérisé en ce que**, en tant que relation rationnelle fractionnaire ou en nombre entier, chaque valeur V = N₁/N₂ peut être réglée par l'unité de processeur numérique (20 ; 220), moyennant quoi N₁ et N₂ sont n'importe quels nombres naturels supérieurs à zéro et peuvent être représentés en tant que nombres intégraux numériques avec au moins 8 bits, de préférence au moins 16 bits et, de manière préférée entre toutes, au moins 32 bits.

17. Analyseur selon l'une quelconque des revendications précédentes, **caractérisé en ce que** la relation rationnelle fractionnaire ou en nombre entier entre la première fréquence de signal (Fs) et l'autre fréquence de signal (Fr ; Ft) ou entre
- la fréquence du signal de commande (Fs) et la fréquence du signal d'horloge (Fclk) ou/et
- la fréquence du signal de déclenchement (Ft) et la fréquence du signal d'horloge (Fclk) ou/et
- la fréquence du signal d'oscillateur local (Fr) et la fréquence du signal d'horloge (Fclk)
peut être réglée par l'unité de processeur numérique (20 ; 120 ; 220), en particulier de façon quasi-continue.

18. Analyseur selon l'une quelconque des revendications précédentes, **caractérisé en ce qu'**une valeur de phase peut être appliquée en entrée au premier générateur de signal (24), et/ou au deuxième générateur de signal (26 ; 226) ou au générateur du signal de déclenchement (26 ; 226) ou/et au deuxième générateur de signal (32 ; 232) afin d'augmenter une phase interne du générateur du signal de sortie respectif (signal de commande (Ss), signal de déclenchement (St) ou signal d'oscillateur local (Sr)), pour chaque cycle du signal d'horloge (Sclk).

19. Analyseur selon la revendication 18, **caractérisé en ce que** la valeur de phase peut être appliquée en entrée sous la forme d'une valeur, qui définit la fréquence (Fs, Fr ou Ft) résultante du signal de sortie du générateur en tant que partie fractionnaire de la fréquence (Fclk) du signal d'horloge.

20. Analyseur selon la revendication 18 ou 19, **caractérisé en ce que** la phase interne du générateur représentée en tant que nombre entier numérique fournit l'adresse d'une valeur d'amplitude associée représentée numériquement du signal de sortie du générateur dans une table (62) interne du générateur, laquelle valeur peut être appliquée à un dispositif de conversion numérique-analogique (64) délivrant le signal de sortie du générateur.

21. Analyseur selon une quelconque des revendications 1 à 17, **caractérisé en ce que** le premier générateur de signal (24) et/ou l'autre générateur de signal (32 ; 232 ; 26 ; 226) ou le générateur du signal de déclenchement (26 ; 226) et/ou le deuxième générateur de signal (32 ; 232) comprend un circuit de boucle de verrouillage de phase (PLL), qui transforme en fréquence le signal d'horloge (Sclk) dans une fréquence plus élevée ou plus basse (Fs) ou (Fr) ou (Fr).

22. Analyseur selon la revendication 21, **caractérisé en ce que** le circuit PLL comprend un élément multiplicateur de fréquence et/ou un élément diviseur de fréquence avec un facteur de multiplication de fréquence ou un facteur diviseur de fréquence pouvant être réglées par l'unité de processeur numérique.

23. Analyseur selon l'une quelconque des revendications 2 à 22 et, dans tous les cas, en référence à la revendication 2 ou 4, **caractérisé en ce que** l'unité de processeur numérique (20 ; 220) reçoit le signal de déclenchement (St) et prend en considération des valeurs d'échantillonnage délivrées par le dispositif de conversion analogique-numérique (16) à des moments définis par le signal de déclenchement.

24. Analyseur selon l'une quelconque des revendications précédentes, **caractérisé en ce que**, afin d'élargir le domaine de fréquences d'un circuit générateur du générateur d'horloge (22 ; 222) et/ou du premier générateur de signal (24), et/ou de l'autre générateur de signal (32 ; 232 ; 26 ; 226) ou du générateur du signal de déclenchement (26 ; 226) et/ou du deuxième générateur de signal (32 ; 232), il est prévu un circuit de transformation de fréquence respectif (70, 72 ou 74), qui est connecté en aval du circuit générateur ou peut être connecté en aval pour certaines conditions opératoires.

25. Analyseur selon la revendication 24, **caractérisé en ce que** le circuit de transformation de fréquence comprend un élément diviseur de fréquence (74) ou/et un élément de mise en puissance de fréquence (70, 72) ou/et un circuit de boucle de verrouillage de phase (PLL) ou/et un élément mélangeur avec l'oscillateur local associé.

26. Analyseur selon l'une quelconque des revendications précédentes, **caractérisé en ce que** la définition de la grandeur caractérisante comprend l'exécution d'une transformée de Fourier numérique sur la base des valeurs d'échantillonnage ou sur la base de ces valeurs de traitement issues d'autres traitements.

27. Analyseur selon la revendication 26, **caractérisé en ce qu'**une grandeur caractérisante comprend l'amplitude relative ou les amplitudes relatives (A1/A2) et la phase relative ou les phases relatives (W1 - W2) entre les composantes de Fourier d'au moins deux signaux de sortie différents (u1, u2) provenant du système à vérifier (SUT), ou/et comprend une amplitude (A1, A2) ou/et au moins une amplitude relative en relation avec le signal de commande (Ss) ou/et au moins une phase relative (W1, W2) en relation avec le signal de commande (Ss) au moins d'une composante de Fourier d'au moins un signal de sortie (u1, u2) provenant du système (SUT) à vérifier.

28. Analyseur selon l'une quelconque des revendications précédentes, **caractérisé en ce que** le générateur d'horloge est un générateur d'horloge interne (122) de l'unité de processeur numérique (120) ou est réalisé sur la base d'un générateur d'horloge interne ainsi que d'autres composants matériels ou/et fonctionnalités logicielles de l'unité de processeur numérique, moyennant quoi le premier générateur de signal ou/et le deuxième générateur de signal ou/et le générateur du signal de déclenchement sont réalisés sur la base de composants matériels de l'unité de processeur numérique (120) ou/et de ces composants matériels externes associés en utilisant des fonctionnalités logicielles de l'unité de processeur numérique (120).

29. Analyseur selon l'une quelconque des revendications 2 à 28, **caractérisé en ce que** le générateur d'horloge (222) comprend un dispositif de conversion de fréquence, de préférence un dispositif de multiplication de fréquence (293, 294), qui convertit la fréquence (Fext) du signal reçu (Ss) dans la fréquence (Fxlk) du signal d'horloge (Sclk).

30. Analyseur selon la revendication 29, **caractérisé en ce que** le dispositif de conversion de fréquence (293, 294) comprend un élément multiplicateur de fréquence ou une boucle de multiplication de fréquence (293), qui multiplie la fréquence (Fext) du signal (Ss) reçu ou une fréquence interne, qui en est dérivée, par un facteur (n) de nombre entier, ou/et **en ce que** le dispositif de conversion de fréquence (293, 294) comprend un élément diviseur de fréquence (294) ou une boucle de division de fréquence, qui diminue la fréquence (Fext) du signal reçu (Ss) ou une fréquence interne, qui en est dérivée, (Fext^{*}n) par un facteur de nombre entier (m).

31. Procédé, en particulier procédé d'analyse de réponse de fréquence, pour mesurer au moins une caractéristique spécifique relative à une fréquence, d'un système à vérifier, le cas échéant la réaction du système à vérifier à au moins un signal de commande (Ss) périodique de fréquence fixe ou variable,
le procédé comprenant :
a1) la délivrance d'un signal d'horloge (Sclk) périodique avec une fréquence d'horloge (Fclk) ;
a2) la délivrance d'un signal de commande (Ss) périodique avec une fréquence de signal de commande variable (Fs), qui a une relation rationnelle fractionnaire ou en nombre entier avec la fréquence du signal d'horloge (Fclk) ;
a3) la transmission du signal de commande à un système à vérifier (SUT) ;
ou comprenant :
b1) la délivrance d'un signal avec une fréquence (Fext) fixe ou variable en association avec un système à vérifier ;
b2) la réception du signal avec la fréquence (Fext) fixe ou variable et la délivrance, sur la base du signal reçu avec la fréquence (Fext) fixe ou variable, d'un signal d'horloge (Sclk) périodique avec une fréquence d'horloge (Fclk), qui a une relation rationnelle fractionnaire ou en nombre entier avec la fréquence (Fext) du signal reçu ;
le procédé comprenant en outre :
c1) la délivrance d'un autre signal (Sr ; St) périodique, pouvant être utilisé en tant que signal d'oscillateur local ou signal de déclenchement, avec une autre fréquence de signal (Fr ; Ft) de préférence variable, qui a une relation rationnelle fractionnaire ou en nombre entier avec la fréquence du signal d'horloge (Fclk) ;
c2) la réception d'au moins un signal de sortie (u1, u2) provenant du système (SUT) à vérifier ;
c3) sur la base de l'autre signal (Sr ; St), la génération de valeurs d'échantillonnage numériques par l'échantillonnage d'un signal représentatif du signal de sortie du système ou correspondant à celui-ci, de telle manière que les valeurs d'échantillonnage numériques représentent la répartition dans le temps de ce signal ;
c4) la définition d'au moins une grandeur caractérisant la caractéristique spécifique, le cas échéant la réaction du système au signal de commande, sur la base des valeurs d'échantillonnage.

32. Procédé selon la revendication 31, **caractérisé en ce que** l'autre signal fait office de signal de déclenchement (St), et le signal représentatif du signal de sortie du système ou correspondant à celui-ci est échantillonné à des moments définis par le signal de déclenchement (St) afin de générer les valeurs d'échantillonnage numériques.

33. Procédé selon la revendication 31, **caractérisé en ce que** l'autre signal fait office de signal d'oscillateur local (Sr) et, sur la base du signal d'oscillateur local (Sr), le signal de sortie du système est mélangé pour être ramené à une fréquence plus basse par rapport au signal de sortie du système, et **en ce qu'**une composante d'un signal générée par le mélange à la baisse, qui présente la plus basse fréquence, est échantillonnée afin de délivrer les valeurs d'échantillonnage numériques.
